(19) Europäisches Patentamt
European Patent Office
Office européen des brevets

(11) EP 4 738 275 A1

(12) EUROPEAN PATENT APPLICATION

(43) Date of publication:
**06.05.2026 Bulletin 2026/19**

(21) Application number: **25212652.9**

(22) Date of filing: **31.10.2025**

(51) International Patent Classification (IPC):
***G06V 10/22*** *(2022.01)* ***G06T 3/00*** *(2024.01)*
***G06V 20/64*** *(2022.01)*

(52) Cooperative Patent Classification (CPC):
**G06V 10/22; G06V 20/64;** G06V 2201/03

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **01.11.2024 JP 2024193101**
**01.11.2024 JP 2024193107**
**28.04.2025 JP 2025074423**

(71) Applicant: **Canon Medical Systems Corporation**
**Otawara-shi, Tochigi 324-0036 (JP)**

(72) Inventor: **TAKESHIMA, Hidenori**
**Otawara-shi, 324-0036 (JP)**

(74) Representative: **Marks & Clerk LLP**
**15 Fetter Lane**
**London EC4A 1BW (GB)**

(54) **IMAGING AREA OUTPUT APPARATUS, IMAGING AREA OUTPUT METHOD, AND IMAGING APPARATUS**

(57) An imaging area output apparatus according to an embodiment includes a processing circuitry. The processing circuitry acquires a template for searching an imaging area. The processing circuitry generates, based on pixel information of each of pixels, an appropriateness map representing an appropriateness degree as the imaging area for each of the pixels. The processing circuitry generates an integral map of the appropriateness map, and calculates an evaluation value as the imaging area of the template by utilizing the integral map with respect to each of disposition ranges of the template to the appropriateness map. The processing circuitry searches a specific disposition range in which the evaluation value satisfies a separately determined condition, and outputs identification data of the imaging area corresponding to the specific disposition range.

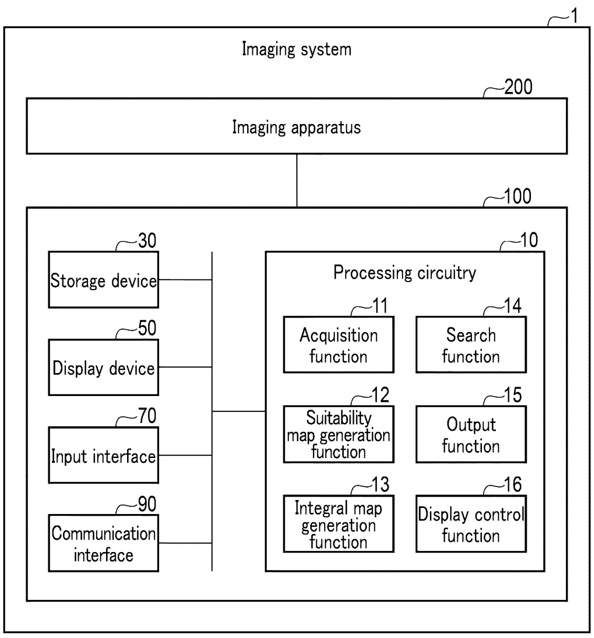


F I G. 1



Processed by Luminess, 75001 PARIS (FR)

## Description

CROSS-REFERENCE TO RELATED APPLICATIONS

This application is based upon and claims the benefit of priority from prior Japanese Patent Application No.2024-193101, filed November 1,2024, No.2024-193107, filed November 1,2024, and No.2025-074423, filed April 28,2025, the entire contents of all of which are incorporated herein by reference.

FIELD

Embodiments described herein relate generally to an imaging area output apparatus, an imaging area output method, and an imaging apparatus.

BACKGROUND

In MR spectroscopy, some automatic search methods relating to a VOI (Volume Of Interest) are known. As one example, there is a method in which a template of the VOI is fitted to a normal brain. In this method, the VOI is quickly determined by utilizing a known shape of the brain and the template of the VOI. However, in this method, since the shape of the brain varies from person to person, the fitting of the template is difficult, and there is concern that the VOI is set on another tissue that is similar in shape.

As another example, there is a method in which a VOI is locally searched by utilizing a segmentation result of abnormality classification. In this method, segmentation of abnormality classification is applied to an image, and a tumor that is an abnormal region is specified. A small template is disposed on the center of the specified tumor, and an operation of one-dimensionally modifying the position of disposition, the dimensions, the rotational angle and the like of the template is repeated three times, thereby determining the VOI. However, in this method, since the position of disposition of the template is not determined globally, it is not ensured that the VOI is set at a suitable position.

SUMMRY

In relation to the embodiments, the following matters are disclosed as one aspect and a selective feature of the present invention.

(Supplementary Note 1)

An imaging area output apparatus including:

an acquisition unit configured to acquire a template for searching an imaging area;
a suitability map generation unit configured to generate, based on pixel information of each of pixels, a suitability map representing a suitability degree as the imaging area for each of the pixels;
an integral map generation unit configured to generate an integral map of the suitability map;
a search unit configured to calculate an evaluation value as the imaging area of the template by utilizing the integral map with respect to each of disposition ranges of the template to the suitability map, and to search a specific disposition range in which the evaluation value satisfies a separately determined condition; and
an output unit configured to output identification data of the imaging area corresponding to the specific disposition range.

(Supplementary Note 2)

The imaging area output apparatus of Supplementary Note 1, wherein the pixel value includes a segmentation value representing a segmentation result for each of the pixels, a shimming value representing an error from a reference frequency, a signal value, and/or a monochromatic or color gradient based on the signal value.

(Supplementary Note 3)

The imaging area output apparatus of Supplementary Note 2, wherein the suitability map generation unit is configured to generate, for each of the pixels, the suitability degree, based on a value acquired by multiplying the segmentation value, the signal value or the gradient by the shimming value.

(Supplementary Note 4)

The imaging area output apparatus of Supplementary Note 1, wherein the search unit is configured to calculate a total value of suitability degrees allocated to the pixels included in the disposition range of the template, by utilizing the integral map, and to calculate the evaluation value, based on the total value.

(Supplementary Note 5)

The imaging area output apparatus of Supplementary Note 4, wherein the search unit is configured to calculate the evaluation value, based on a correction value obtained by correcting the total value by a size of the template.

(Supplementary Note 6)

The imaging area output apparatus of Supplementary Note 1, wherein the search unit is configured to change the disposition range of the template with respect to the suitability map by varying a combination of the position of disposition, a rotational angle, dimensions, and/or a shape of the template with respect to the suitability map.

(Supplementary Note 7)

The imaging area output apparatus of Supplementary Note 6, wherein as regards two or more disposition ranges having a relationship of rotational angles of 0 degrees, 90 degrees, 180 degrees and 270 degrees, the search unit is configured to apply the evaluation value of one of the two or more disposition ranges to the evaluation values of the other disposition ranges of the two or more disposition ranges.

(Supplementary Note 8)

The imaging area output apparatus of Supplementary Note 7, wherein shapes of the two or more templates corresponding to the two or more disposition ranges are right-angled tetragonal shapes.

(Supplementary Note 9)

The imaging area output apparatus of Supplementary Note 1, wherein the search unit is configured to calculate the evaluation value with respect to the position of disposition while changing the position of disposition of the template in a search position range that is set on the appropriate degree map.

(Supplementary Note 10)

The imaging area output apparatus of Supplementary Note 1, wherein the search unit is configured to:

calculate the evaluation value while changing a position of disposition and/or a rotational angle with respect to each of the templates with different combinations of shapes and dimensions, and select a plurality of disposition ranges corresponding to the templates; and
determine, based on the selected disposition ranges, the specific disposition range in which the evaluation value satisfies the condition.

(Supplementary Note 11)

The imaging area output apparatus of Supplementary Note 1, wherein the search unit is configured to execute calculation of the evaluation value and selection of the specific disposition range while changing in multiple stages a search range of the position of disposition, the rotational angle, the dimensions and/or the shape.

(Supplementary Note 12)

The imaging area output apparatus of Supplementary Note 11, wherein all sides of the template are parallel to any one of coordinate axes of the suitability map.

(Supplementary Note 13)

The imaging area output apparatus of Supplementary Note 1, wherein

the search unit is configured to rotate the suitability map at a plurality of rotational angles in an absolute coordinate system;
the integral map generation unit is configured to generate the integral map of the rotated suitability map in the absolute coordinate system with respect to each of the rotational angles; and
the search unit is configured to dispose the template on the rotated suitability map in such a manner that at least one side of the template is parallel to any one of coordinate axes of the absolute coordinate system, to calculate the evaluation value of the template in the disposition range, and to select the specific disposition range in which the evaluation value satisfies the condition.

(Supplementary Note 14)

The imaging area output apparatus of Supplementary Note 1, wherein the search unit is configured to apply to the evaluation value a penalty for making smaller the evaluation value as a difference between a length of each of axes of the template and a desired length becomes larger.

(Supplementary Note 15)

The imaging area output apparatus of Supplementary Note 14, wherein the search unit is configured to apply the penalty to the evaluation value in a case where the evaluation value satisfies a predetermined condition, and to reject a search result relating to the specific disposition range in a case where the evaluation value fails to satisfy the predetermined condition.

(Supplementary Note 16)

The imaging area output apparatus of Supplementary Note 15, wherein the search unit is configured to determine that the evaluation value satisfies the predetermined condition, in a case where the evaluation value is not less than a multiplication value between a proportionality factor and lengths of axes of the template, or in a case where the evaluation value is not less than a preset minimum evaluation value.

(Supplementary Note 17)

An imaging area output method including:

acquiring a template for searching an imaging area;
generating, based on pixel information of each of pixels, a suitability map representing a suitability degree as the imaging area for each of the pixels;
generating an integral map of the suitability map;
calculating an evaluation value as the imaging area of the template by utilizing the integral map with respect to each of disposition ranges of the template to the suitability map, and searching a specific disposition range in which the evaluation value satisfies a separately determined condition; and
outputting identification data of the imaging area corresponding to the specific disposition range.

(Supplementary Note 18)

An imaging apparatus including an imaging unit configured to perform imaging on an imaging area corresponding to identification data of the imaging area that is output from the imaging area output apparatus of any one of Supplementary Notes 1 to 16.

(Supplementary Note 19)

An integral data string processing apparatus including:

an input unit configured to input an input data string that is a data string of two or more dimensions;
a first generation unit configured to generate a converted input data string by applying separately determined one-to-one conversion to the input data string;
a second generation unit configured to generate an integral data string that is a data string acquired by integrating the converted input data string in one or more dimensions; and
a calculation unit configured to calculate, by utilizing the integral data string, an integral value of data values of the input data string in the disposition range of the template disposed on the converted input data string.

(Supplementary Note 20)

The integral data string processing apparatus of Supplementary Note 19, further including a specifying unit, wherein

an evaluation value based on the integral value is calculated by utilizing the integral data string with respect to each of the disposition ranges; and
the specifying unit is configured to search a specific disposition range in which the evaluation value satisfies a separately determined condition.

(Supplementary Note 21)

The integral data string processing apparatus of Supplementary Note 20, further including a disposing unit, wherein

the first generation unit is configured to generate the converted input data string acquired by reversely rotating the input data string by a predetermined rotational angle, thereby to search the specific disposition range by using the template that is forwardly rotated by the predetermined rotational angle relative to the input data string; and
the disposing unit is configured to dispose the template, which is unrotated, on the converted input data string.

(Supplementary Note 22)

The integral data string processing apparatus of Supplementary Note 21, wherein

the first generation unit is configured to generate the converted input data strings that are reversely rotated by a plurality of rotational angles; and
the specifying unit is configured to search the specific disposition range with respect to each of the converted input data strings, and to specify a disposition range in which the evaluation value is highest among the specific disposition ranges of the converted input data strings.

(Supplementary Note 23)

The integral data string processing apparatus of Supplementary Note 19, wherein the one-to-one conversion is rotation.

(Supplementary Note 24)

The integral data string processing apparatus of Supplementary Note 19, wherein the one-to-one conversion is affine transformation.

(Supplementary Note 25)

The integral data string processing apparatus of Supplementary Note 19, wherein the second generation unit is configured to generate the integral data string that is a data string acquired by integrating the converted input data string in all dimensions of the converted input data string.

(Supplementary Note 26)

The integral data string processing apparatus of Supplementary Note 19, wherein the input data string is image data.

(Supplementary Note 27)

The integral data string processing apparatus of Supplementary Note 21, wherein the specifying unit is configured to search the specific disposition range while changing a position of disposition of the template, dimensions of the template, and a rotational angle of the input data string, to change, each time the rotational angle of the input data string is changed, the position of disposition of the template with respect to a combination selected by a separately determined method of the dimensions of the template, and to search the specific disposition range.

(Supplementary Note 28)

The integral data string processing apparatus of Supplementary Note 27, wherein the separately determined method uses a method of any one of a first-dimensional search, a second-dimensional search, a third-dimensional complete search, a multi-stage search and a diamond search in regard to a position, and uses a method of any one of a first-dimensional search, a second-dimensional search, a third-dimensional complete search and a multi-stage search in regard to dimensions.

(Supplementary Note 29)

An integral data string processing method including:

inputting an input data string that is a data string of two or more dimensions;
generating a converted input data string by applying separately determined one-to-one conversion to the input data string;
generating an integral data string that is a data string acquired by integrating the converted input data string in one or more dimensions; and
calculating, by utilizing the integral data string, an integral value of data values of the input data string in the disposition range of the template disposed on the converted input data string.

(Supplementary Note 30)

An integral data string processing program causing a computer to implement:

a function of inputting an input data string that is a data string of two or more dimensions;
a function of generating a converted input data string by applying separately determined one-to-one conversion to the input data string;
a function of generating an integral data string that is a data string acquired by integrating the converted input data string in one or more dimensions; and
a function of calculating, by utilizing the integral data string, an integral value of data values of the input data string in the disposition range of the template disposed on the converted input data string.

BRIEF DESCRIPTION OF THE DRAWINGS

FIG. 1 is a diagram illustrating a configuration example of an imaging system according a first embodiment.
FIG. 2 is a diagram illustrating a processing procedure of an imaging area search process by an imaging area output apparatus according to the first embodiment.
FIG. 3 is a diagram schematically illustrating a generation process of a suitability map in steps SA2 and SA3 of FIG. 2.
FIG. 4 is a diagram illustrating a generation process of an integral map in step SA4 of FIG. 2.
FIG. 5 is a diagram exemplarily illustrating a calculation method of a total value of suitability degrees in step SA6 of FIG. 2.
FIG. 6 is a diagram schematically illustrating an example of a simple automatic search process of steps SA5 to SA8 of FIG. 2.
FIG. 7 is a diagram schematically illustrating an example of processing of steps SA5 to SA8 using a multiple template method.
FIG. 8 is a diagram schematically illustrating an example of processing of steps SA5 to SA8 using a multi-stage search method.
FIG. 9 is a diagram illustrating an example of a display screen of identification data of an optimal imaging area.

FIG. 10 is a diagram illustrating a processing procedure of a search process of a suitability map rotation type.
FIG. 11 is a diagram schematically illustrating a processing procedure of steps SB4 to SB8 of FIG. 10.
FIG. 12 is a diagram illustrating a configuration example of an imaging system according a second embodiment.
FIG. 13 is a diagram illustrating a processing procedure of a region-of-interest search process by an integral data string processing apparatus according to the second embodiment.
FIG. 14 is a diagram schematically illustrating a generation process of a suitability map from pixel information in steps SC2 and SC3 of FIG. 13.
FIG. 15 is a diagram illustrating a generation process of an integral map in step SC4 of FIG. 13.
FIG. 16 is a diagram exemplarily illustrating a calculation method of a total value of suitability degrees in step SC6 of FIG. 13.
FIG. 17 is a diagram schematically illustrating an example of a simple automatic search process of steps SC5 to SC8 of FIG. 13.
FIG. 18 is a diagram schematically illustrating an example of processing of steps SC5 to SC8 using a multiple template method.
FIG. 19 is a diagram schematically illustrating an example of processing of steps SC5 to SC8 using a multi-stage search method.
FIG. 20 is a diagram illustrating an example of a display screen of identification data of an optimal region of interest.
FIG. 21 is a diagram exemplarily illustrating a functional configuration of a search function according to a third embodiment.
FIG. 22 is a diagram illustrating a processing procedure of a region-of-interest search process according to the third embodiment.
FIG. 23 is a diagram schematically illustrating a processing procedure of steps SD1 to SD8 of FIG. 21.
FIG. 24 is a diagram schematically illustrating an example of a search process using a multi-thread method.
FIG. 25 is a diagram illustrating a concrete example relating to a part of the search process illustrated in FIG. 22.

## DETAILED DESCRIPTION

An imaging area output apparatus according to one embodiment includes a processing circuitry. The processing circuitry acquires a template for searching an imaging area. The processing circuitry generates, based on pixel information of each of pixels, a suitability map representing a suitability degree as the imaging area for each of the pixels. The processing circuitry generates an integral map of the suitability map, and calculates an evaluation value as the imaging area of the template by utilizing the integral map with respect to each of disposition ranges of the template to the suitability map. The processing circuitry searches a specific disposition range in which the evaluation value satisfies a separately determined condition, and outputs identification data of the imaging area corresponding to the specific disposition range.
Hereinafter, referring to the accompanying drawings, a description is given of an imaging area output apparatus, an imaging area output method and an imaging apparatus according the embodiment.

### (First embodiment)

FIG. 1 is a diagram illustrating a configuration example of an imaging system 1 according the first embodiment. The imaging system 1 is a machine system including an imaging area output apparatus 100 and an imaging apparatus 200. The imaging area output apparatus 100 and the imaging apparatus 200 are mutually communicably coupled by wired or wireless communication.
The imaging apparatus 200 is an apparatus that images an imaging area and collects imaging data relating to the imaging area. The imaging area that is an imaging target is determined by the imaging area output apparatus 100. The type of the imaging apparatus 200 is not particularly limited, and may be, for example, a medical image diagnosing apparatus, an optical camera apparatus, an optical microscope, an electron microscope, or the like. The medical image diagnosing apparatus may be a single modality apparatus such as a magnetic resonance imaging apparatus, an X-ray computed tomography apparatus (X-ray CT apparatus), an X-ray diagnosing apparatus, an ultrasonic diagnosing apparatus, a photoacoustic diagnosing apparatus, a PET (Positron Emission Tomography) apparatus, a SPECT (Single Photon Emission CT) apparatus, or an optical coherence tomography apparatus (fundus camera), or may be a multi-modality apparatus such as a PET/CT apparatus, a SPECT/CT apparatus, a PET/MRI apparatus, or a SPECT/MRI apparatus.
As illustrated in FIG. 1, the imaging area output apparatus 100 is a computer that outputs identification data of an imaging area that is an imaging target of the imaging apparatus 200. The identification data of the imaging area is sent to the imaging apparatus 200. As illustrated in FIG. 1, the imaging area output apparatus 100 includes a processing circuitry 10, a storage device 30, a display device 50, an input interface 70, and a communication interface 90. Data communication between the processing circuitry 10, storage device 30, display device 50, input interface 70 and communication interface 90 is executed via a bus.

The processing circuitry 10 includes a processor such as a CPU (Central Processing Unit). The processor starts various programs installed in a non-transitory computer-readable storage medium such as the storage device 30, thereby implementing an acquisition function 11, a suitability map generation function 12, an integral map generation function 13, a search function 14, an output function 15, and a display control function 16. The functions 11 to 16 are not necessarily implemented by a single processing circuitry. A plurality of independent processors may be combined to constitute a processing circuitry, and the various processors may execute programs, thereby implementing the functions 11 to 16.

By the acquisition function 11, the processing circuitry 10 acquires various data. In one example, the processing circuitry 10 acquires a template for searching an imaging area. The template can vary a position of disposition, a rotational angle, dimensions, and/or a shape thereof. The template is also called a mask. In another example, the processing circuitry 10 acquires pixel information of each of pixels of an image (hereinafter "source image") that serves as a source of an integral map that is used for searching the imaging area. The source image includes at least pixel information of the imaging area. The source image may be an image generated by the imaging apparatus 200, or may be an image acquired by processing this image.

By the suitability map generation function 12, the processing circuitry 10 generates, based on the pixel information of each pixel acquired by the acquisition function 11, a suitability map representing a suitability degree as the imaging area for each pixel. Suitability degrees are allocated to the pixels of the suitability map, and the suitability map represents a spatial distribution of the suitability degrees.

By the integral map generation function 13, the processing circuitry 10 generates an integral map of the suitability map generated by the suitability map generation function 12. In the pixels of the integral map, integral values of pixel values (suitability degrees) of pixels included in areas divided by the pixels and the origin of the suitability map are allocated, and the integral map represents a spatial distribution of the integral values.

By the search function 14, the processing circuitry 10 calculates, for each of disposition ranges of the template to the suitability map, an evaluation value as the imaging area of the template by utilizing the integral map generated by the integral map generation function 13, and searches a specific disposition range in which the evaluation value satisfies a separately determined condition. The disposition range means a set of pixels of the area in which the template is disposed in the suitability map. The disposition range varies depending on the combination of the position of disposition, rotational angle, dimensions, and/or shape of the template with respect to the suitability map. The processing circuitry 10 changes the disposition range of the template with respect to the suitability map by varying the combination of the position of disposition, rotational angle, dimensions, and/or shape of the template with respect to the suitability map. The processing circuitry 10 calculates an evaluation value, based on the total value of suitability degrees allocated to the pixels included in the disposition range of the template. At this time, the processing circuitry 10 may calculate the evaluation value, based on a correction value obtained by correcting the total value by the size of the template (for example, the area in a case of two dimensions, or the volume in a case of three dimensions). The total value is calculated by utilizing the integral map. The separately determined condition is typically set to be a condition (hereinafter "optimal condition") for an optimal disposition range (hereinafter "optimal disposition range) to be selected as a specific optimal range.

By the output function 15, the processing circuitry 10 outputs identification data of the imaging area corresponding to the specific disposition range selected by the search function 14. The identification data of the imaging area is data capable of identifying the imaging area, and means, for example, image data of the imaging area, or position data of the imaging area.

By implementing the display control function 16, the processing circuitry 10 causes the display device 50 to display various information. For example, the processing circuitry 10 displays the source image, suitability map, integral map, specific disposition range, identification data of the imaging area, and the like.

The storage device 30 is a storage device storing various data, such as a ROM (Read-Only Memory), a RAM (Random Access Memory), an HDD (Hard Disk Drive), an SSD (Solid State Drive), or an integrated circuitry storage device. Aside from these storage devices, the storage device 30 may be a portable storage medium such as a CD (Compact Disc), a DVD (Digital Versatile Disc) or a flash memory, or may be a drive unit that reads and writes various information from and to semiconductor memory elements or the like.

The display device 50 displays various data in accordance with the display control function 16 of the processing circuitry 10. As the display device 50, use may be made of, as appropriate, a liquid crystal display (LCD), a cathode ray tube (CRT) display, an organic electro-luminescence display (OELD), a plasma display, or other freely selected displays. Besides, the display device 50 may be a projector.

The input interface 70 accepts various input operations from a user, converts the accepted input operations into electric signals, and outputs the electric signals to the processing circuitry 10. Specifically, the input interface 7 is connected to input devices, such as a mouse, a keyboard, a track ball, a switch, a button, a joystick, a touch pad, and a touch panel display. The input interface 70 outputs an electric signal corresponding to the input operation to the input device to the processing circuitry 10. In addition, the input device connected to the input interface 70 may be an input device provided on another computer connected via a network or the like. The input interface 70 may be a speech recognition device that converts a speech signal collected by a microphone into an instruction signal.

The communication interface 90 is an interface for connection to various computers via a LAN (Local Area Network) or the like. For example, a LAN card, a network adaptor, a network interface card, or the like is used as the communication interface 90.

Next, the details of the imaging area output apparatus 100 according to the first embodiment are described.

In the embodiment below, it is assumed that the imaging apparatus 200 is a magnetic resonance imaging apparatus. The magnetic resonance imaging apparatus is capable of implementing various imaging methods such as magnetic resonance imaging and MR spectroscopy, and the present embodiment is applicable to any kind of imaging method for collecting data of an imaging area. The imaging area in the magnetic resonance imaging is also called an ROI (Region Of Interest), and the imaging area in the MR spectroscopy is also called a VOI (Volume Of Interest). In addition, an image according to the present embodiment is applicable to each of a two-dimensional image and a three-dimensional image, and is assumed to be a two-dimensional image, unless otherwise mentioned.

FIG. 2 is a diagram illustrating a processing procedure of an imaging area search process by the imaging area output apparatus 100 according to the first embodiment. As illustrated in FIG. 2, the processing circuitry 10 acquires a template by the acquisition function 11 (step SA1). In step SA1, a template in which a rotational angle, dimensions, and a shape are set at default values may be acquired. The rotational angle means an angle around a central point of the template. The dimensions mean a size of the template, and are represented by an enlargement ratio, a reduction ratio, actual dimension values, or the like. The shape means a geometrical shape of the template, and may be a right-angled tetragon, such as a rectangle or a square, or a freely selected shape composed of a combination of right-angled tetragons.

If step SA1 is executed, the processing circuitry 10 acquires pixel information of a source image (step SA2). The source image may be a medical image such as an MR image, or may be a processed image acquired by processing the medical image. A signal value, and/or a monochrome or color gradient based on the signal value, is allocated to the medical image. In the case of an MR image, the signal value means a T1 weighting value or a T2 weighting value. As the processed image, for example, a segmentation image, which is generated by executing a segmentation process on the medical image, is assumed. The kind of segmentation may be determined in accordance with an imaging target. For example, in a case where a specific tissue is an imaging target, segmentation for classifying the specific tissue may be performed, and in a case where an abnormal region such as a tumor is an imaging target, segmentation for classifying abnormality may be performed. In addition, a shimming map may be acquired as the source image. The shimming map is an image representing a spatial distribution of shimming values that represent an error from a reference frequency. As described above, the pixel information according to the present embodiment means the segmentation value representing the segmentation result for each pixel, the shimming value representing the error from the reference frequency, the signal value, and/or the monochromatic or color gradient based on the signal value. Note that a coil sensitivity map may be used in place of the shimming map. The coil sensitivity map is an image representing sensitivity to a spatial position of a transmitter coil or a receiver coil.

If step SA2 is executed, the processing circuitry 10 generates, by the suitability map generation function 12, a suitability map, based on the pixel information acquired in step SA2 (step SA3). Specifically, the processing circuitry 10 calculates the suitability degree for each pixel, based on a value acquired by multiplying the segmentation value, the signal value or the gradient by the shimming value.

FIG. 3 is a diagram schematically illustrating a generation process of the suitability map in steps SA2 and SA3. As illustrated in FIG. 3, in step SA2, an MR image I1, which is collected by the magnetic resonance imaging apparatus 200, is acquired. The MR image I1 may be any kind of image that can be collected by the magnetic resonance imaging apparatus 200, such as a T1 weighted image, a T2 weighted image, a FLAIR (Fluid Attenuated Inversion Recovery) image, a diffusion weighted image, or an MRA (MR Angiography) image. In addition, in FIG. 3, although an examination region is assumed to be the head by way of example, the examination region may be any region, such as the chest region, abdominal region, or limbs.

As illustrated in FIG. 3, in one example, the MR image I1 is an axial plane image of the head. A brain region I11 is extracted in the MR image I1, and a tumor region I12 is extracted in the brain region I11. The imaging area search process aims at setting an imaging area in the optimal disposition range in the tumor region 112. The processing circuitry 10 generates, by the acquisition function 11, a segmentation image I2 by executing a segmentation process of abnormality classification on the MR image I1. In the segmentation process, the processing circuitry 10 calculates, with respect to each pixel of the MR image I1, a likelihood (hereinafter "abnormality degree") that a bodily tissue corresponding to the pixel is abnormal. The abnormality degree is an example of the segmentation value. Note that a numerical value, which is acquired by expressing the abnormality degree as a binary value or a multiple value by setting a predetermined threshold as a boundary, may be set as the segmentation value. The segmentation value is a value scaled in a predetermined range, to be more specific, in a range of from 0 to 1. The value, which is closer to 1, means that this value is more appropriate as the imaging area. In other words, the segmentation value is designed such that the value becomes closer to 1 as the abnormality degree becomes higher. The segmentation image I2 represents a spatial distribution of segmentation values. The segmentation image I2 of FIG. 3 illustrates that a tumor region I21 has a higher segmentation value than other regions.

As illustrated in FIG. 3, the processing circuitry 10 acquires a shimming map I3 by the acquisition function 11. The shimming map I3 represents a spatial distribution of shimming values representing errors from the reference frequency. The shimming value is a value scaled in a predetermined range, to be more specific, in a range of from 0 to 1. The value, which is closer to 1, means that this value is more appropriate as the imaging area. In other words, the shimming value is designed such that the value becomes closer to 0 as the error from the reference frequency becomes greater. It is assumed that the shimming map I3 is collected in advance by the magnetic resonance imaging apparatus 200, and is transferred to the imaging area output apparatus 100.

The processing circuitry 10 calculates, for each pixel of the segmentation image I2, the suitability degree, based on the value acquired by multiplying the segmentation value by the shimming value, and generates a suitability map I4 in which suitability degrees are allocated to the pixels. For example, the processing circuitry 10 calculates, as the suitability degree, a value acquired by multiplying the segmentation value by the shimming value. The appropriateness value is a value scaled in a predetermined range, to be more specific, in a range of from 0 to 1. The value, which is closer to 1, means that this pixel is more appropriate as the imaging area. The suitability map I4 of FIG. 3 illustrates that a region I41, which is approximated to the tumor region I21, has a higher suitability degree than other regions.

If step SA3 is executed, the processing circuitry 10 generates, by the integral map generation function 13, an integral map of the suitability map generated in step SA3 (step SA4).

FIG. 4 is a diagram illustrating a generation process of an integral map I5 in step SA4. In a pixel of the integral map I5, an integral value of suitability degrees of pixels included in an area of a predetermined shape divided by the pixel and an origin P50 of the integral map I5 is allocated. The origin P50 can be set at a freely selected point of the integral map I5. For example, it is assumed that the origin P50 is set at a pixel at an upper left end. The area of the predetermined shape is set to be a right-angled tetragonal area having the origin P50 as an upper left end and having the pixel as a lower right end. For example, in the case of a pixel P51, the processing circuitry 10 calculates an integral value of a plurality of suitability degrees corresponding to a plurality of pixels included in a right-angled tetragonal area I51 having the origin P50 as the upper left end and having the pixel P51 as the lower right end, and allocates the calculated integral value to the pixel P51. Similarly, as regards pixels P52, P53 and P54, integral values of suitability degrees corresponding to the respective pixels included in right-angled tetragonal areas I52, I53 and I54 are allocated as pixel values. The integral map I5 is generated by performing similar processes for all the pixels of the suitability map.

If step SA4 is executed, the processing circuitry 10 disposes, by the search function 14, a template on the suitability map generated in step SA3 (step SA5). An initial position of disposition of the template is not particularly limited, and may be automatically set, or may be designated by the user. The initial rotational angle, dimensions, and shape of the template may be set at freely selected default values. The disposition range of the template to the suitability map is specified by the combination of the position of disposition, rotational angle, dimensions and shape of the template.

If step SA5 is executed, the processing circuitry 10 calculates, by the search function 14, an evaluation value in the disposition range of the template to the suitability map (step SA6). At first, the processing circuitry 10 calculates the evaluation value, based on the total value of suitability degrees allocated to the pixels included in the disposition range of the template that is disposed on the suitability map. Specifically, the processing circuitry 10 calculates the total value of suitability degrees. In order to calculate the total value of suitability degrees, there is no need to add the suitability degrees too simply over all the pixels included in the disposition range. Using the integral map, the processing circuitry 10 calculates the total value of suitability degrees allocated to the pixels included in the disposition range of the template, and calculates the evaluation value, based on the total value. Thereby, it becomes possible to reduce the calculation load of the total value and, by extension, the evaluation value.

FIG. 5 is a diagram exemplarily illustrating a calculation method of the total value of suitability degrees in step SA6. As illustrated in FIG. 5, it is assumed that an image area (disposition range) I55 of the integral map I5 is set. The disposition range I55 is an image area that is set at the same position as the disposition range of the template on the suitability map. In FIG. 5, it is assumed that the total value of suitability degrees of the disposition range I55 is calculated. The disposition range I55 is a right-angled tetragonal area surrounded by pixels P51, P52, P53 and P54. As described above, in the pixels of the integral map I5, integral values of suitability degrees of all pixels included in the right-angled tetragonal areas divided by the origin P50 and the pixels are allocated. Thus, the processing circuitry 10 can simply calculate a total value V55 of suitability degrees of the disposition range I55 by using only addition and/or subtraction of pixel values V51, V52, V53 and V54 of the pixels P51, P52, P53 and P54. In one example, the total value V55 can be calculated according to an equation (1) below.

$$V55 = V54 - (V52 + V53 - V51) \qquad (1)$$

Note that in the case of a three-dimensional image, it is similarly possible to simply calculate a total value of suitability degrees by using only addition and/or subtraction of pixel values of some representative pixels (for example, eight pixels) of a three-dimensional disposition range. Moreover, in the case of a search of an area expressed by a combination of right-angled tetragons, it is similarly possible to perform a calculation using only some representative values of the right-angled tetragons constituting this area.

The processing circuitry 10 uses, as the evaluation value, the total value calculated by the above-described method. Since the evaluation value is the total value of suitability degrees, this means that the degree of appropriateness of the disposition range as the imaging area is greater as the evaluation value becomes greater. In this case, as the size of the template becomes greater, the evaluation value becomes greater. Thus, in a case of comparing the evaluation values of the disposition ranges of the same size of the templates, the total value may be used as the evaluation value. However, in a case of comparing the evaluation values of the disposition ranges of different sizes of the templates, the processing circuitry 10 may calculate the evaluation value, based on a correction value obtained by correcting the total value by the volume of the template. The correction method is not particularly limited, and, for example, a value obtained by dividing the total value by the size of the template can be used as the correction value. According to this evaluation value, the degree of appropriateness as the imaging area can be evaluated without depending on the size of the template.

In addition, a value, which is obtained by applying a penalty according to a freely selected standard to the total value of suitability degrees or the correction value of the total value, may be used as the evaluation value. In one example, in a case where there are dimensions of the imaging area, which are expected by the user, a penalty, which becomes greater as the error between the expected value of dimensions and the template (disposition range) becomes greater, may be applied to the total value of suitability degrees or the correction value. In another example, in a case where the appropriateness as the imaging area tends to be more lost as the shape of the template becomes more complex, a penalty, which becomes greater as the dimensions become more complex, may be applied to the total value of suitability degrees or the correction value.

If step SA6 is executed, the processing circuitry 10 determines whether or not to change the position of disposition, dimensions, rotational angle, and/or shape (step SA7). In step SA7, the processing circuitry 10 determines whether an ending condition for the change of the position of disposition, rotational angle, dimensions, and/or shape is satisfied or not. The ending condition may be set to be such a condition that all search ranges of the position of disposition, rotational angle, dimensions, and/or shape are completed, that the evaluation value has reached a predetermined value, or that the number of times of change has reached a predetermined number. If the ending condition is not satisfied, the processing circuitry 10 determines that the position of disposition, rotational angle, dimensions, and/or shape is changed. If the ending condition is satisfied, the processing circuitry 10 determines that the position of disposition, rotational angle, dimensions, and/or shape is not changed.

In step SA7, if it is determined that the position of disposition, rotational angle, dimensions, and/or shape is changed (step SA7: YES), the processing circuitry 10 changes the position of disposition, rotational angle, dimensions, and/or shape of the template, and repeats steps SA5 to SA7. The processing circuitry 10 repeats steps SA5 to SA7 while changing the disposition range specified by the position of disposition, rotational angle, dimensions, and/or shape, until determining that the position of disposition, rotational angle, dimensions, and/or shape is not changed.

Here, as regards two or more disposition ranges having a relationship of rotational angles of 0 degrees, 90 degrees, 180 degrees and 270 degrees, the processing circuitry 10 applies the evaluation value of one of the two or more disposition ranges to the evaluation values of the other disposition ranges of the two or more disposition ranges. At this time, the shapes of two or more templates corresponding to the two or more disposition ranges are right-angled tetragonal shapes. For example, in the case where templates have rectangular shapes, evaluation values can be applied to each other with respect to the combination of rotational angles of 0 degrees and 180 degrees or the combination of rotational angles of 90 degrees and 270 degrees. In the case where templates have square shapes, evaluation values can be applied to each other with respect to the combination of rotational angles of 0 degrees, 90 degrees, 180 degrees and 270 degrees. By making applicable use of evaluation values, the calculation load of evaluation values can be reduced.

In step SA7, if it is determined that the position of disposition, rotational angle, dimensions, and/or shape is not changed (step SA7: NO), the processing circuitry 10 determines, by the search function 14, an optimal disposition range that satisfies an optimal condition (step SA8). The optimal condition is typically set to be such a condition that the evaluation value calculated in step SA6 is highest. In this case, the disposition range with the highest evaluation value is determined as the optimal disposition range. Note that the optimal condition is not limited to this, and may be such a condition that the evaluation value is a freely selected designation value. The designation value may be designated by the user, or may be designated according to a freely selected algorithm.

Here, referring to FIG. 6 to FIG. 8, the details of steps SA5 to SA8 are described. FIG. 6 is a diagram schematically illustrating an example of a simple search process of steps SA5 to SA8. As illustrated in FIG. 6, the processing circuitry 10 sets a global search position range I61 in a suitability map I6. The search position range I61 means a search range of the disposition range. In one example, the search position range I61 may be set in such a manner as to include a region I62 having a relatively high suitability degree in the suitability map I6. In one example, the region I62 is assumed to be the region I41 of the suitability map I4 illustrated in FIG. 3. The shape of the search position range I61 is not limited to a rectangular shape illustrated in FIG. 6, and may be set to a freely selected shape, as described above. Note that the search position range I61 may be set on the entirety of the suitability map I6.

The region I62 is not limited to one region as illustrated in FIG. 6, and is also assumed to be two or more regions. In this case, the search position range I61 may be set in such a manner as to include a part or all of the two or more regions.

As illustrated in FIG. 6, the processing circuitry 10 disposes a template T6 of a predetermined rotational angle, shape and dimensions at a search start position of the search position range I61. The shape of the template T6 is not limited to a rectangle illustrated in FIG. 6, and may be a square or a freely selected shape composed of a combination of right-angled tetragons, as described above. In the case of disposing the template T6, the processing circuitry 10 calculates the evaluation value based on the total value of suitability degrees, by using the above-described calculation method.

If the evaluation value is calculated, the processing circuitry 10 changes the position of disposition of the template T6, and similarly calculates the evaluation value with respect to the disposition range. In this manner, the processing circuitry 10 calculates the evaluation value with respect to each position of disposition, while changing the position of disposition of the template T6 in the search position range I61. The processing circuitry 10 may continuously dispose the template T6 in such a manner as to move to all areas in the search position range I61, or may discretely dispose the template T6 in representative areas. If the processing circuitry 10 completes disposing at all scheduled positions in the search position range I61, the processing circuitry 10 selects, as the optimal position of disposition, the position of disposition that satisfies the optimal condition among the evaluation values corresponding to the positions of disposition. In the case of a single-stage search in which a single search range is a target, as illustrated in FIG. 6, it is expected that the optimal imaging area is an optimal solution, as long as the suitability map is accurate. In other words, it can be ensured that the imaging area does not become a non-optimal solution.

In the simple search process illustrated in FIG. 6, it is assumed that the rotational angle, shape and dimensions of the template T6 are fixed, but the present embodiment is not limited to this. In one example, the processing circuitry 10 calculates the evaluation value while changing the position of disposition and/or rotational angle with respect to each of templates with different combinations of shapes and dimensions, selects a plurality of disposition ranges corresponding to the templates, and determines, based on the selected disposition ranges, the optimal disposition range in which the evaluation value satisfies the optimal condition. This search process method is referred to as a multiple template method. Note that it is not necessary that both the shape and the dimensions are different, and either the shape or the dimensions may be identical.

FIG. 7 is a diagram schematically illustrating an example of processing of steps SA5 to SA8 using a multiple template method. The number of templates used in the multiple template method may be any number of two or more, and FIG. 7 exemplarily illustrates a case of two templates. As illustrated in an upper part of FIG. 7, the processing circuitry 10 uses two templates T71 and T72 having different combinations of a shape and dimensions. In one example, it is assumed that the shape of the template T71 is rectangular and the dimensions thereof are 80% of the default value, and the shape of the template T72 is square and the dimensions thereof are 100% of the default value.

The processing circuitry 10 disposes each of the two templates T71 and T72, individually, in a search position range I71 of a suitability map I7, calculates the evaluation value while changing the position of disposition and/or the rotational angle and fixing the shape and dimensions, searches the optimal disposition range by using the evaluation value, as described above, and selects the optimal disposition range. In addition, based on an optimal disposition range R71 of the template T71 and an optimal disposition range R72 of the template T72, the processing circuitry 10 determines a final version of the optimal disposition range R73. In one example, the processing circuitry 10 may select, as the final range R73, the disposition range having a higher evaluation value between the optimal disposition range R71 of the template T71 and the optimal disposition range R72 of the template T72. In another example, the processing circuitry 10 may select, as the final range R73, the disposition range acquired by weighted addition of evaluation values between the optimal disposition range R71 of the template T71 and the optimal disposition range R72 of the template T72. By parallelizing the templates having multiple shapes and/or dimensions, the optimal disposition range can efficiently be searched.

It is assumed that the search process illustrated in FIG. 6 and FIG. 7 is a single-stage search having a single search range as a target. However, the present embodiment is not limited to this. In one example, the processing circuitry 10 may execute the calculation of the evaluation value and the determination of the optimal disposition range while changing in multiple stages the search range of the position of disposition, rotational angle, dimensions and/or shape. This search process method is referred to as a multi-stage search method.

FIG. 8 is a diagram schematically illustrating an example of processing of steps SA5 to SA8 using the multi-stage search method. The number of search stages in the multi-stage search method may be any number of two or more, and FIG. 8 exemplarily illustrates a case of three stages. As illustrated in an upper part of FIG. 8, in a first stage, the processing circuitry 10 disposes a template T81 on a suitability map I8. The position of disposition of the template T81 is limited to a global search position range I81. In one example, it is assumed that the dimension of each side of the search position range I81 is about 6 cm. It is assumed that the rotational angle, dimensions and shape are fixed to freely selected values. In the first stage, the processing circuitry 10 calculates the evaluation value while changing the position of disposition of the template T81 in the search position range I81 and fixing the rotational angle, dimensions and shape of the template T81, and determines the optimal disposition range by using the evaluation value, as described above.

In a second stage, it is assumed that the dimensions and shape are fixed to the same values as in the first stage. The position of disposition of a template T82 is limited to a local search position range I82 that includes the optimal disposition range of the first stage and is narrower than the global search position range I81. It is assumed that the dimension of each side of the search position range I82 is, for example, about 1 to 4 cm. In the case of rotating the right-angled tetragonal template T82, in order to secure the accuracy of the evaluation value, it is preferable that all sides of the template after disposition are parallel to any one of coordinate axes of the integral map I8. Specifically, the rotational angle is set to four rotational angles, namely 0°, 90°, 180°, and 270°. In the second stage, with respect to each of the four rotational angles, the processing circuitry 10 calculates the evaluation value while changing the position of disposition of the template T82 in the search position range I82 and fixing the dimensions and shape of the template T82, and determines the optimal disposition range by using the evaluation value, as described above.

In a third stage, the position of disposition of a template T83 is limited to an identical search position range I83 to the optimal disposition range of the second stage. The rotational angle is successively changed within a local angle range including the rotational angle of the optimal disposition range of the second stage. For example, if the rotational angle of the optimal disposition range of the second stage is 90°, the search range of the rotational angle of the third stage is set in the angle range of 45° to 135°. The search range of dimensions is set to, for example, a range of dimensions of 50% to 200%, and the shape is assumed to be three kinds, namely a rectangle, a square and a convex shape. In the third stage, with respect to the three shapes, the processing circuitry 10 calculates the evaluation value while changing the position of disposition of the template T83 in the search position range I83, changing the dimensions of the template T83 in the range of dimensions of 50% to 200% and changing the rotational angle in the angle range of 45° to 135° at a predetermined angular interval (for example, 10°), and determines the optimal disposition range by using the evaluation value, as described above. The optimal disposition range of the third stage is used as the final range. Identification data of the optimal disposition range is stored in the storage device 30. By using the multi-stage search method, it is expected that the optimal imaging area is the optimal solution, as long as the suitability map is accurate and the optimal solution is included in the optimal disposition range that is narrowed down in the stage before the final stage. In addition, compared to the single-stage search method, since the multi-stage search method narrows down the optimal disposition range in multiple stages, the optimal solution can be acquired in a short time.

If step SA8 is executed, the processing circuitry 10 outputs, by the output function 15, the identification data of the imaging area (hereinafter "optimal imaging area") corresponding to the optimal disposition range selected in step SA8 (step SA9). The identification data of the optimal imaging area is image data of the image area corresponding to the optimal disposition range, or position data of this image area.

If step SA9 is executed, the processing circuitry 10 displays, by the display control function 16, the identification data of the optimal imaging area that is output in step SA9 (step SA10). In step SA10, the processing circuitry 10 causes the display device 50 to display the display screen of the identification data of the optimal imaging area for the user's confirmation.

FIG. 9 is a diagram illustrating an example of a display screen IS1 of the identification data of the optimal imaging area. As illustrated in FIG. 9, for example, an MR image IS11 relating to the axial plane of the head is displayed on the display screen IS1. In the MR image IS11, a tumor region IS12 of the brain is depicted. A mark IS13 indicating the identification data of the optimal imaging area selected in step SA8 is rendered on the tumor region IS12. By the disposition or the like of the mark IS13, the user can confirm whether the optimal imaging area is appropriate.

An OK button IS14 and an NG button IS15 may be displayed on the display screen IS1. The OK button IS14 is a GUI (Graphical User Interface) part for confirming the optimal imaging area. If the OK button IS14 is pressed via the input interface 70, the optimal imaging area is confirmed. The NG button IS15 is a GUI part for rejecting the optimal imaging area. If the NG button IS15 is pressed via the input interface 70, the processing circuitry 10 rejects the optimal imaging area. In this case, the processing circuitry 10 may repeat the process of steps SA5 to SA7 once again from default values. Alternatively, the processing circuitry 10 may correct the optimal imaging area by changing the position of disposition, rotational angle, dimensions and/or shape of the mark IS13 on the display screen IS1. After the correction, if the OK button IS14 is pressed via the input interface 70, the processing circuitry 10 confirms the image area indicated by the mark IS13 as the optimal imaging area. The identification data of the confirmed optimal imaging area is stored in the storage device 30.

If the OK button IS14 is pressed, the processing circuitry 10 ends the imaging area search process illustrated in FIG. 2. Thereafter, the identification data of the optimal imaging area is transferred to the imaging apparatus 200 by the processing circuitry 10. Then, the imaging apparatus 200 performs imaging on the optimal imaging area corresponding to the received identification data. Since the imaging is performed on the optimal imaging area, it is expected that imaging is accurately performed on a desired area.

Note that the imaging area search process illustrated in FIG. 2 is merely an example, and the present embodiment is not limited to this, and various omissions, additions and/or changes to the processing can be made without departing from the spirit of the invention. In one example, the template acquisition step (SA1) may be executed in any order before the template disposing step (SA5). In another example, the display step (SA10) of the identification data of the optimal imaging area can be omitted.

A correction value calculation process and a penalty applying process (hereinafter, these processes are comprehensively referred to as "evaluation value correction process") in the processing circuitry 10 are described in detail. As one example of the description of the evaluation value correction process, a case is considered in which a template has a right-angled tetragonal shape having lengths (Lx, Ly, Lz) along the respective axes. As an example of a standard in the evaluation value correction in this case, consideration is given to desired lengths (bx, by, bz) for the respective axes in a three-dimensional space, exponential penalty coefficients (wx, wy, wz) for errors from the desired lengths, a proportionality factor q of a minimum evaluation value that is proportional to a template area, and a minimum evaluation value Emin that does not depend on the template shape. An evaluation value before the application of the evaluation value correction process is expressed by Eraw.

If the evaluation value satisfies a predetermined condition, the processing circuitry 10 applies a penalty to the evaluation value. If the evaluation value fails to satisfy the predetermined condition, the processing circuitry 10 rejects a search result relating to the disposition range of the template. The predetermined condition means a condition for a transition to the evaluation value correction process. For example, the processing circuitry 10 determines that the predetermined condition is not satisfied, if the evaluation value Eraw is less than a multiplication value between the proportionality factor q and the lengths Lx, Ly and Lz of the respective axes of the template ($Eraw < qLxLyLz$), or if the evaluation value Eraw is less than a preset minimum evaluation value ($Eraw < Emin$). In this case, the processing circuitry 10 rejects the search result. Note that, as an equivalent process to the rejection of the search result, the processing circuitry 10 may set, for example, the evaluation value Eraw at $-\infty$.

On the other hand, if the evaluation value Eraw is not less than the multiplication value qLxLyLz, or if the evaluation value Eraw is not less than the preset minimum evaluation value Emin, the processing circuitry 10 determines that the predetermined condition is satisfied, and executes the evaluation value correction process. In other words, the processing circuitry 10 executes the evaluation value correction process, only in the case where the search result is not rejected. In the evaluation value correction process, the processing circuitry 10 applies to the evaluation value Eraw a penalty for making smaller the evaluation value as the difference between the lengths (Lx, Ly, Lz) of the respective axes of the template and the desired lengths (bx, by, bz) becomes larger. To be more specific, the processing circuitry 10 applies a stronger penalty as a value obtained by multiplying the difference between the lengths (Lx, Ly, Lz) of the respective axes of the template and the desired lengths (bx, by, bz) by the exponential penalty coefficients becomes larger. For example, if an L1 distance is adopted as a difference in length, an evaluation value Epost after the evaluation value correction process can be expressed by the following equation (2).

$$Epost = Eraw \cdot \exp(-(wx|Lx-bx|+wy|Ly-by|+wz|Lz-bz|)) \quad (2)$$

The difference in length may be, not the L1 distance, but other distance (for example, L2 distance). Since the position dependency of the evaluation value can be expressed as a suitability degree, the evaluation value correction process can be, in many cases, a process that does not depend on the position of disposition and depends on only other search targets (for example, rotational angle, dimensions of the template, and the shape of the template). In this case, without changing the other search targets, the search of the position of disposition is processed batchwise, and the evaluation value correction process is applied to the optimal evaluation value in the batches process, and thereby the evaluation value correction process can be applied in a short calculation time.

In the imaging area search process illustrated in FIG. 2, in order to set the imaging area on the abnormal region such as a tumor, the segmentation result of the abnormality classification is assumed to be used. However, the present embodiment is not limited to this. In one example, the imaging area may be set on a normal brain region or the like. In this case, the processing circuitry 10 applies segmentation of region classification to the MR image of the head, and generates a suitability map, based on the segmentation result in which the likelihood of the brain region is expressed to a numerical value. Accordingly, the present embodiment is also applicable to the case of setting the imaging area on the normal region.

In the imaging area search process illustrated in FIG. 2, it is assumed that the suitability map is generated based on the segmentation result. However, the present embodiment is not limited to this. In one example, the processing circuitry 10 may generate the suitability map, based on the MR image in which a contrast medium is rendered (hereinafter "contrast image"). A gradient (density value) having a value corresponding to the density of the contrast medium is allocated to the pixel of the contrast image. In this case, the processing circuitry 10 may calculate the suitability degree, based on a value acquired by multiplying the gradient by the shimming value, for each of the pixels of the contrast image. Thereby, the imaging area can be set on a blood vessel region that is image-enhanced by the contrast medium.

In the imaging area search process illustrated in FIG. 2, it is assumed that the imaging area, which is the imaging target of the imaging apparatus 200, is searched. However, the present embodiment is not limited to this. In one example, the embodiment is applicable to any process of searching a region of interest included in an image by using a template. As such processes, the embodiment is applicable to a face recognition algorithm by Viola et al. (Viola, P.; Jones, M. (2001). "Rapid object detection using a boosted cascade of simple features". Proceedings of the 2001 IEEE Computer Society Conference on Computer Vision and Pattern Recognition. CVPR 2001) or to image recognition for object detection or the like.

Here, the change of the rotational angle of the template is described in detail. In one example, the processing circuitry 10 disposes an unrotated template on a suitability map after reverse rotation. Hereinafter, this imaging area search process is referred to as a search process of a suitability map rotation type.

FIG. 10 is a diagram illustrating a processing procedure of a search process of a suitability map rotation type. In the search process of the suitability map rotation type, the processing circuitry 10 first executes the template acquisition step (SA1), image information acquisition step (SA2) and suitability map generation step (SA3) of FIG. 2.

If step SA3 is executed, the processing circuitry 10 reversely rotates the suitability map generated in step SA3 by the search function 14 (step SB4). If step SB4 is executed, the processing circuitry 10 generates, by the integral map generation function 13, the integral map, based on the suitability map reversely rotated in step SB4 (step SB5). If step SB5 is executed, the processing circuitry 10 disposes, by the search function 14, the template acquired in step SA1 on the reversely rotated suitability map generated in step SB4 (step SB6). If step SB6 is executed, the processing circuitry 10 calculates, by the search function 14, the evaluation value in the disposition range of the template by utilizing the integral map (step SB7). If step SB7 is executed, the processing circuitry 10 determines, by the search function 14, whether the position of disposition, dimensions and/or shape is changed (step SB8). In step SB8, the processing circuitry 10 determines whether an ending condition for the change of the position of disposition, dimensions, and/or shape is satisfied or not. The ending condition may be set to be such a condition that all search ranges of the position of disposition, dimensions, and/or shape are completed, that the evaluation value has reached a predetermined value, or that the number of times of change has reached a predetermined number. If the ending condition is not satisfied, the processing circuitry 10 determines that the position of disposition, dimensions, and/or shape is changed. If the ending condition is satisfied, the processing circuitry 10 determines that the position of disposition, dimensions, and/or shape is not changed.

Here, referring to FIG. 11, steps SB4 to SB8 are described in detail. FIG. 11 is a diagram schematically illustrating a processing procedure of steps SB4 to SB8. As illustrated in an uppermost stage of FIG. 11, in step SB4, the processing circuitry 10 first disposes a suitability map I91 generated in step SA3 on a world coordinate system (absolute coordinate system) W1. The world coordinate system W1 is an image processing space defined by an orthogonal coordinate system specified by an abscissa axis X and an ordinate axis Y. In the world coordinate system W1, lattice points (pixels) are arrayed along orthogonal three axes. The suitability map I91 is disposed such that the abscissa axis is parallel to the X axis and the ordinate axis is parallel to the Y axis. The suitability map I91 includes an area I92 having a high suitability degree. It is expected that an optimal imaging area is disposed in the optimal range of the area I92.

Next, as illustrated in a second stage of FIG. 11, the processing circuitry 10 reversely rotates the suitability map I91 in the world coordinate system W1. In the imaging area search process illustrated in FIG. 2, the template is rotated in the forward direction. In the search process of the suitability map rotation type illustrated in FIG. 10, the suitability map is rotated in the reverse direction (reversely rotated). The absolute value of the rotational angle of the reverse rotation is equal to the absolute value of the rotational angle of the template with respect to the suitability map in the imaging area search process. For example, FIG. 11 exemplarily illustrates a case of reverse rotation over 45°. The processing circuitry 10 allocates, to the respective lattice points of the world coordinate system W1, the suitability degrees of the corresponding pixels of the suitability map I91 after rotation. In a case where the lattice points of the world coordinate system W1 do not coincide with the positions of the pixels of the suitability map I91 after rotation, the suitability degrees allocated to the respective lattice points may be calculated by applying a super-resolution technique, such as by displacing the suitability map I91 by a 0.5 pixel.

Next, as illustrated in a third stage of FIG. 11, the processing circuitry 10 generates an integral map I93 in the world coordinate system W1, based on the suitability map I91 after reverse rotation. The integral map I93 is disposed such that the horizontal axis is parallel to the X axis and the ordinate axis is parallel to the Y axis. The dimensions of the integral map I93 are set in such a manner as to include the suitability map I91. For example, the integral map I93 is set in such a manner as to circumscribe the suitability map I91 after reverse rotation. The processing circuitry 10 calculates an integral value of a plurality of suitability degrees corresponding to a plurality of pixels included in a right-angled tetragonal area I94 having an origin P90 of the integral map I93 as the upper left end and having a target pixel P91 as the lower right end, and allocates the calculated integral value to the target pixel P91. The right-angled tetragonal area I94 is disposed such that the abscissa axis is parallel to the X axis and the ordinate axis is parallel to the Y axis. The integral map I93 is generated by performing this process for all the pixels included in the integral map I93.

Next, as illustrated in a fourth stage of FIG. 11, a template T9 is disposed in a search area I94 that is set in the suitability map I91. The template T9 is disposed such that the abscissa axis is parallel to the X axis and the ordinate axis is parallel to the Y axis. The template T9 is disposed without rotation relative to the suitability map I91 that was rotated in the reverse direction as described above, and thereby the template T9 rotates in the forward direction relative to the suitability map I91. Thereafter, the processing circuitry 10 repeats the calculation of the evaluation value in the disposition range and the change of the position of disposition, dimensions and/or shape, and searches the optimal disposition range of the template T9, based on the evaluation value. By scanning the reversely rotated suitability map I91 by the unrotated template T9, it becomes possible to scan the unrotated suitability map in a nonparallel and nonperpendicular manner to the coordinate axes by the template T9. In other words, it becomes possible to execute a process equivalent to a process of scanning the unrotated suitability map by the forwardly rotated template.

If it is determined in step SB8 that the position of disposition, dimensions and/or shape is not changed (step SB8: NO), the processing circuitry 10 determines, by the search function 14, whether or not to change the rotational angle (step SB9). Specifically, the processing circuitry 10 determines whether the process of steps SB4 to SB8 has been executed for all rotational angles of the search angle range. If the process of steps SB4 to SB8 has not been executed for all rotational angles of the search angle range, the processing circuitry 10 determines that the rotational angle is changed. In this case, the processing circuitry 10 executes the process of steps SB4 to SB8 for a non-processed rotational angle of the search angle range. In this manner, steps SB4 to SB8 are repeated until there remains no non-processed rotational angle.

In addition, if it is determined in step SB9 that the rotational angle is not changed (step SB9: NO), the processing circuitry 10 executes the optimal disposition range determination step (SA8), the output step (SA9) of the identification data of the optimal imaging area, and the identification data display step (SA10). Thereby, the search process of the suitability map rotation type illustrated in FIG. 10 is completed.

Note that the search process illustrated in FIG. 10 is merely an example, and the present embodiment is not limited to this, and various omissions, additions and/or changes to the processing can be made without departing from the spirit of the invention. In one example, the template acquisition step (SA1) may be executed in any order before the template disposing step (SB6). In another example, the display step (SA10) of the identification data of the optimal imaging area can be omitted.

According to some embodiments described above, the imaging area output apparatus 100 includes the processing circuitry 10. The processing circuitry 10 acquires the template for searching the imaging area. Based on the pixel information of each pixel, the processing circuitry 10 generates the suitability map representing the appropriateness as the imaging area for each pixel. The processing circuitry 10 generates the integral map of the suitability map. The processing circuitry 10 calculates, for each disposition range of the template to the suitability map, the evaluation value as the imaging area of the template by utilizing the integral map, and searches the specific disposition range in which the evaluation value satisfies the separately determined condition. The processing circuitry 10 outputs the identification data of the imaging area corresponding to the specific disposition range.

According to the above-described configuration, the evaluation value as the imaging area of the template is acquired by utilizing the integral map of the suitability map, and the disposition range of the template is searched based on the evaluation value. Thus, the imaging area can be acquired in a short time and with a light load, while decreasing the possibility of leading to a local solution. In addition, since the processing circuitry 10 acquires the suitability map by utilizing the image information of the segmentation result or the like, the processing circuitry 10 can reduce the possibility that the imaging area is set on an undesired tissue.

In the above embodiment, the processing circuitry 10 disposes the unrotated template on the reversely rotated suitability map. However, the present embodiment is not limited to this. For example, the processing circuitry 10 may dispose a forwardly rotated template on an unrotated suitability map. In this case, in order to dispose the rotated template on the integral map in the case of changing the rotational angle of the template, it is necessary to rotate the search target data and calculate the integral map thereof. In this calculation, for example, instead of setting the horizontal direction at +1, the horizontal direction is set at +1 and the vertical direction is set at -1, and instead of setting the vertical direction at +1, the horizontal direction is set at -1 and the vertical direction is set at +1. Thereby, an integral map that is rotated over 45 degrees is generated on the space in which the spatial distance is scaled with $\sqrt{2}$ times magnification, and a search can be performed on the integral map. In this case, at a time of rotating the template, it is necessary to include a correction calculation for the spatial distance. Note that this method can be applied to an angle other than 45 degrees, for example, in such a manner that, instead of setting the horizontal direction at +1, the horizontal direction is set at +1 and the vertical direction is set at -2 (the spatial distance is scaled with $\sqrt{5}$ times magnification). In addition, this method can be applied to a freely chosen angle by using a rounding process of the position.

According to at least one of the above-described embodiments, an appropriate imaging area can be acquired under a restriction of a short processing time.

(Second Embodiment)

FIG. 12 is a diagram illustrating a configuration example of an imaging system 2 according a second embodiment. The imaging system 2 is a machine system including an integral data string processing apparatus 300 and an imaging apparatus 400. The integral data string processing apparatus 300 and the imaging apparatus 400 are mutually communicably coupled by wired or wireless communication.

The imaging apparatus 400 is an apparatus that images an imaging area and collects imaging data relating the imaging area. The type of the imaging apparatus 400 is not particularly limited, and use may be made of, for example, an optical camera apparatus, an optical sensor or an infrared sensor apparatus built in a monitoring apparatus, a medical image diagnosing apparatus, an optical microscope, an electron microscope, or the like. The medical image diagnosing apparatus may be a single modality apparatus such as a magnetic resonance imaging apparatus, an X-ray computed tomography apparatus (X-ray CT apparatus), an X-ray diagnosing apparatus, an ultrasonic diagnosing apparatus, a photoacoustic diagnosing apparatus, a PET apparatus, a SPECT apparatus, or an optical coherence tomography apparatus (fundus camera), or may be a multi-modality apparatus such as a PET/CT apparatus, a SPECT/CT apparatus, a PET/MRI apparatus, or a SPECT/MRI apparatus.

FIG. 12 illustrates a configuration example of the integral data string processing apparatus 300. The integral data string processing apparatus 300 is a computer that outputs identification data of a region of interest of the imaging apparatus 400. As illustrated in FIG. 12, the integral data string processing apparatus 300 includes a processing circuitry 310, a storage device 330, a display device 350, an input interface 370, and a communication interface 390. Data communication between the processing circuitry 310, storage device 330, display device 350, input interface 370 and communication interface 390 is executed via a bus.

The processing circuitry 310 includes a processor such as a CPU, an FPGA, or an ASIC. The processor starts various programs installed in a non-transitory computer-readable storage medium such as the storage device 330, thereby implementing an acquisition function 311, a suitability map generation function 312, an integral map generation function 313, a search function 314, an output function 315, and a display control function 316. The functions 311 to 316 are not necessarily implemented by a single processing circuitry. A plurality of independent processors may be combined to constitute a processing circuitry, and the various processors may execute programs, thereby implementing the functions 311 to 316.

By the acquisition function 311, the processing circuitry 310 acquires various data. In one example, the processing circuitry 310 acquires a template for searching a region of interest. The template can vary a position of disposition, a rotational angle, dimensions, and/or a shape thereof. The template is also called a mask. In another example, the processing circuitry 310 acquires pixel information of each of pixels of an image (hereinafter "source image") that serves as a source of an integral map that is used for searching the region of interest. The source image includes at least pixel information of the region of interest. The source image may be an image generated by the imaging apparatus 400, or may be an image acquired by processing this image.

By the suitability map generation function 312, the processing circuitry 310 generates, based on pixel information of each pixel acquired by the acquisition function 311, a suitability map representing an suitability degree as the region of interest for each pixel. Suitability degrees are allocated to the pixels of the suitability map, and the suitability map represents a spatial distribution of the suitability degrees.

By the integral map generation function 313, the processing circuitry 310 generates an integral map of the suitability map generated by the suitability map generation function 312. In the pixels of the integral map, integral values of pixel values (suitability degrees) of pixels included in areas divided by the pixels and the origin of the suitability map are allocated, and the integral map represents a spatial distribution of the integral values.

By the search function 314, the processing circuitry 310 calculates, for each disposition range of the template to the suitability map, an evaluation value as a region of interest of the template by utilizing the integral map generated by the integral map generation function 313, and searches a specific disposition range in which the evaluation value satisfies a separately determined condition. The disposition range means a set of pixels of the area in which the template is disposed in the suitability map. The disposition range varies depending on the combination of the position of disposition, rotational angle, dimensions, and/or shape of the template with respect to the suitability map. The processing circuitry 310 changes the disposition range of the template with respect to the suitability map by varying the combination of the position of disposition, rotational angle, dimensions, and/or shape of the template with respect to the suitability map. The processing circuitry 310 calculates an evaluation value by using the integral map, based on the total value of suitability degrees allocated to the pixels included in the disposition range of the template. At this time, the processing circuitry 310 may calculate the evaluation value, based on a correction value obtained by correcting the total value by the size of the template (for example, the area in a case of two dimensions, or the volume in a case of three dimensions). The separately determined condition is typically set to be a condition (hereinafter "optimal condition") for an optimal disposition range (hereinafter "optimal disposition range") to be selected as a specific optimal range.

By the output function 315, the processing circuitry 310 outputs identification data of the region of interest corresponding to the specific disposition range selected by the search function 314. The identification data of the region of interest is data that can identify the region of interest, and means, for example, image data or position data of the region of interest.

By implementing the display control function 316, the processing circuitry 310 causes the display device 350 to display various information. For example, the processing circuitry 310 displays the source image, suitability map, integral map, specific disposition range, identification data of the region of interest, and the like.

The storage device 330 is a storage device storing various data, such as a ROM, a RAM, an HDD, an SSD, or an integrated circuitry storage device. Aside from these storage devices, the storage device 330 may be a portable storage medium such as a CD, a DVD or a flash memory, or may be a drive unit that reads and writes various information from and to semiconductor memory elements or the like. Besides, the storage device 330 may include a cache structure for a higher data access speed.

The display device 350 displays various data in accordance with the display control function 316 of the processing circuitry 310. As the display device 350, use may be made of, as appropriate, a liquid crystal display (LCD), a CRT display, an organic electro-luminescence display (OELD), a plasma display, or other freely selected displays. Besides, the display device 350 may be a projector.

The input interface 370 accepts various input operations from a user, converts the accepted input operations into electric signals, and outputs the electric signals to the processing circuitry 310. Specifically, the input interface 370 is connected to input devices, such as a mouse, a keyboard, a track ball, a switch, a button, a joystick, a touch pad, and a touch panel display. The input interface 370 outputs an electric signal corresponding to the input operation to the input device to the processing circuitry 310. In addition, the input device connected to the input interface 370 may be an input device provided on another computer connected via a network or the like. The input interface 370 may be a speech recognition device that converts a speech signal collected by a microphone into an instruction signal.

The communication interface 390 is an interface for connection to various computers via a LAN or the like. For example, a LAN card, a network adaptor, a network interface card, or the like is used as the communication interface 390.

Next, the details of the integral data string processing apparatus 300 according to the present embodiment are described.

In the embodiment below, the imaging apparatus 400 is assumed to be an infrared camera apparatus. Aside from this, for example, the embodiment is applicable to three-dimensional volume data used in a medical image. The image according to the present embodiment is applicable to either a two-dimensional image or a three-dimensional image, but it is assumed that the image is a two-dimensional image unless otherwise mentioned.

FIG. 13 is a diagram illustrating a processing procedure of a region-of-interest search process by the integral data string processing apparatus 300 according to the present embodiment. As illustrated in FIG. 13, the processing circuitry 310 acquires a template by the acquisition function 311 (step SC1). In step SC1, a template in which a rotational angle, dimensions, and a shape are set at default values may be acquired. The rotational angle means an angle around a central point of the template. The dimensions mean a size of the template, and is represented by an enlargement ratio, a reduction ratio, actual dimension values, or the like. The shape means a geometrical shape of the template, and may be a right-angled tetragon, such as a rectangle or a square, or a freely selected shape composed of a combination of right-angled tetragons.

If step SC1 is executed, the processing circuitry 310 acquires pixel information of a source image by the acquisition function 311 (step SC2). The source image may be, for example, an image input from an infrared camera apparatus (hereinafter "infrared camera image"), or may be a processed image acquired by processing the infrared camera image. A signal value, and/or a monochrome or color gradient based on the signal value, is allocated to the infrared camera image. As the processed image, for example, an image obtained by applying various pre-process filters to the infrared camera image, or a segmentation image, which is generated by executing a segmentation process on the infrared camera image, is assumed. The kind of segmentation may be determined in accordance with an imaging target. For example, in a case where a specific animal or plant is an imaging target, the processed image can be acquired by performing segmentation for classifying the specific animal or plant.

If step SC2 is executed, the processing circuitry 310 generates, by the suitability map generation function 312, a suitability map, based on the pixel information acquired in step SC1 (step SC3). For example, the processing circuitry 310 calculates the suitability degree for each pixel in accordance with the segmentation value, the signal value or the gradient.

FIG. 14 is a diagram schematically illustrating a generation process of the suitability map from the pixel information in steps SC2 and SC3. As illustrated in FIG. 14, in step SC2, an image I31, which is collected by the infrared camera apparatus 400, is acquired. The image I31 includes monochromatic pixel information.

As illustrated in FIG. 14, as an example, an image I31, which is obtained by monitoring a crow perching on an electric cable by the infrared camera apparatus 400 provided on a utility pole, is assumed. The image I31 includes an image area (crow area) I311 relating to the crow, and an image area (electric cable area) I312 relating to the electric cable on which the crow perches. The region-of-interest search process aims at setting a region of interest in the optimal disposition range in the crow area I311. The processing circuitry 310 generates, by the acquisition function 311, a segmentation image I32 by executing a segmentation process of area classification on the image I31. In the segmentation process, the processing circuitry 310 calculates, with respect to each pixel of the image I31, a likelihood (hereinafter "crow likelihood degree") that a substantial body corresponding to the pixel is a crow. The crow likelihood degree is an example of the segmentation value. Note that a numerical value, which is acquired by expressing the crow likelihood degree as a binary value or a multiple value by setting a predetermined threshold as a boundary, may be set as the segmentation value. The segmentation value is a value scaled in a predetermined range, to be more specific, in a range of from 0 to 1. The value, which is closer to 1, means that this value is more appropriate as the region of interest. In other words, the segmentation value is designed such that the value becomes closer to 1 as the crow likelihood degree becomes higher. As the segmentation value is closer to 1, this means that the pixel is appropriate as the region of interest. A segmentation map is used as the suitability map. The suitability map I32 of FIG. 14 illustrates that the crow area I321 has a higher suitability degree than other areas.

Note that the suitability map may be generated by applying a threshold process to the source image. In one example, in a case where the source image is an optical camera image, a suitability map can be generated by extracting a pixel with a specific color value by the threshold process. To be more specific, a color value range that the crow area can have is preset as a threshold range, and the pixel value of a pixel belonging to the threshold range is set at value "1", and the pixel value of a pixel that does not belong to the threshold range is set a value "0". Thereby, the suitability map can be generated.

If step SC3 is executed, the processing circuitry 310 generates, by the integral map generation function 313, an integral map of the suitability map generated in step SC3 (step SC4).

FIG. 15 is a diagram illustrating a generation process of an integral map I35 in step SC4. In a pixel of the integral map I35, an integral value of suitability degrees of pixels included in an area of a predetermined shape divided by the pixel and an origin P350 of the integral map I35 is allocated. The origin P350 can be set at a freely selected point of the integral map I35. For example, it is assumed that the origin P350 is set at a pixel at an upper left end. The area of the predetermined shape is set to be a right-angled tetragonal area having the origin P350 as an upper left end and having the pixel as a lower right end. For example, in the case of a pixel P351, the processing circuitry 310 calculates an integral value of a plurality of suitability degrees corresponding to a plurality of pixels included in a right-angled tetragonal area I351 having the origin P350 as the upper left end and having the pixel P351 as the lower right end, and allocates the calculated integral value to the pixel P351. Similarly, as regards pixels P352, P353 and P354, integral values of suitability degrees corresponding to the respective pixels included in right-angled tetragonal areas I352, I353 and I354 are allocated as pixel values. The integral map I35 is generated by performing similar processes for all the pixels of the suitability map.

If step SC4 is executed, the processing circuitry 310 disposes, by the search function 314, a template on the suitability map generated in step SC3 (step SC5). The position of disposition of an initial template is not particularly limited, and may be automatically set, or may be designated by the user. The rotational angle, dimensions, and shape of the initial template may be set at freely selected default values. The disposition range of the template to the suitability map is specified by the combination of the position of disposition, rotational angle, dimensions and shape of the template.

If step SC5 is executed, the processing circuitry 310 calculates, by the search function 314, an evaluation value in the disposition range of the template to the suitability map (step SC6). At first, the processing circuitry 310 calculates the evaluation value, based on the total value of suitability degrees allocated to the pixels included in the disposition range of the template that is disposed on the suitability map. Specifically, the processing circuitry 310 first calculates the total value of suitability degrees. In order to calculate the total value of suitability degrees, there is no need to add the suitability degrees too simply over all the pixels included in the disposition range. Using the integral map, the processing circuitry 310 calculates the total value of suitability degrees allocated to the pixels included in the disposition range of the template, and calculates the evaluation value, based on the total value. Thereby, it becomes possible to reduce the calculation load of the total value and, by extension, the evaluation value.

FIG. 16 is a diagram exemplarily illustrating a calculation method of the total value of suitability degrees in step SC6. As illustrated in FIG. 16, it is assumed that an image area (disposition range) I355 of the integral map I35 is set. The disposition range I355 is an image area that is set at the same position as the disposition range of the template on the suitability map. In FIG. 16, it is assumed that the total value of suitability degrees of the disposition range I355 is calculated. The disposition range I355 is a right-angled tetragonal area surrounded by pixels P351, P352, P353 and P54. As described above, in the pixels of the integral map I35, integral values of suitability degrees of all pixels included in the right-angled tetragonal areas divided by the origin P350 and the pixels are allocated. Thus, the processing circuitry 310 can simply calculate a total value V355 of suitability degrees of the disposition range I355 by using only addition and/or subtraction of pixel values V351, V352, V353 and V354 of the pixels P351, P352, P353 and P354. In one example, the total value V355 can be calculated according to an equation (3) below.

$$V355 = V354 - (V352 + V353 - V351) \qquad (3)$$

Note that in the case of a three-dimensional image, it is similarly possible to simply calculate a total value of suitability degrees by using only addition and/or subtraction of pixel values of some representative pixels (for example, six pixels) of a three-dimensional disposition range. Moreover, in the case of a search of an area expressed by a combination of right-angled tetragons, it is similarly possible to perform a calculation using only some representative values of the right-angled tetragons constituting this area.

The processing circuitry 310 uses, as the evaluation value, the total value calculated by the above-described method. Since the evaluation value is the total value of suitability degrees, this means that the degree of appropriateness of the disposition range as the region of interest is greater as the evaluation value becomes greater. In this case, as the size of the template becomes greater, the evaluation value becomes greater. Thus, in a case of comparing the evaluation values of the disposition ranges of the same size of the templates, the total value may be used as the evaluation value. However, in a case of comparing the evaluation values of the disposition ranges of different sizes of the templates, the processing circuitry 310 may calculate the evaluation value, based on a correction value obtained by correcting the total value by the volume of the template. The correction method is not particularly limited, and, for example, a value obtained by dividing the total value by the size of the template can be used as the correction value. According to this evaluation value, the degree of appropriateness as the region of interest can be evaluated without depending on the size of the template.

In addition, a value, which is obtained by applying a penalty according to a freely selected standard to the total value of suitability degrees or the correction value of the total value, may be used as the evaluation value. In one example, in a case where there are dimensions of the region of interest, which are expected by the user, a penalty, which becomes greater as the error between the expected value of dimensions and the template (disposition range) becomes greater, may be applied to the total value of suitability degrees or the correction value. In another example, in a case where the appropriateness as the region of interest tends to be more lost as the shape of the template becomes more complex, a penalty, which becomes greater as the dimensions become more complex, may be applied to the total value of suitability degrees or the correction value.

If step SC6 is executed, the processing circuitry 310 determines whether or not to change the position of disposition, dimensions, rotational angle, and/or shape (step SC7). In step SC7, the processing circuitry 310 determines whether an ending condition for the change of the position of disposition, rotational angle, dimensions, and/or shape is satisfied or not. The ending condition may be set to be such a condition that all search ranges of the position of disposition, rotational angle, dimensions, and/or shape are completed, that the evaluation value has reached a predetermined value, or that the number of times of change has reached a predetermined number. If the ending condition is not satisfied, the processing circuitry 310 determines that the position of disposition, rotational angle, dimensions, and/or shape is changed. If the ending condition is satisfied, the processing circuitry 310 determines that the position of disposition, rotational angle, dimensions, and/or shape is not changed.

In step SC7, if it is determined that the position of disposition, rotational angle, dimensions, and/or shape is changed (step SC7: YES), the processing circuitry 310 changes the position of disposition, rotational angle, dimensions, and/or shape of the template, and repeats steps SC5 to SC7. The processing circuitry 310 repeats steps SC5 to SC7 while changing the disposition range specified by the position of disposition, rotational angle, dimensions, and/or shape, until determining that the position of disposition, rotational angle, dimensions, and/or shape is not changed.

Here, as regards two or more disposition ranges having a relationship of rotational angles of 0 degrees, 90 degrees, 180 degrees and 270 degrees, the processing circuitry 310 applies the evaluation value of one of the two or more disposition ranges to the evaluation values of the other disposition ranges of the two or more disposition ranges. At this time, the shapes of two or more templates corresponding to the two or more disposition ranges are right-angled tetragonal shapes. For example, in the case where templates have rectangular shapes, evaluation values can be applied to each other with respect to the combination of rotational angles of 0 degrees and 180 degrees or the combination of rotational angles of 90 degrees and 270 degrees. In the case where templates have square shapes, evaluation values can be applied to each other with respect to the combination of rotational angles of 0 degrees, 90 degrees, 180 degrees and 270 degrees. By making applicable use of evaluation values, the calculation load of evaluation values can be reduced.

In step SC7, if it is determined that the position of disposition, rotational angle, dimensions, and/or shape is not changed (step SC7: NO), the processing circuitry 310 determines, by the search function 314, an optimal disposition range that satisfies an optimal condition (step SC8). The optimal condition is typically set to be such a condition that the evaluation value calculated in step SC6 is highest. In this case, the disposition range with the highest evaluation value is determined as the optimal disposition range. Note that the optimal condition is not limited to this, and may be such a condition that the evaluation value is a freely selected designation value. The designation value may be designated by the user, or may be designated according to a freely selected algorithm.

Here, referring to FIG. 17 to FIG. 19, the details of steps SC5 to SC8 are described. FIG. 17 is a diagram schematically illustrating an example of a simple search process of steps SC5 to SC8. As illustrated in FIG. 17, the processing circuitry 310 sets a global search position range I361 in a suitability map I36. The search position range I361 means a search range of the disposition range. In one example, the search position range I361 may be set in such a manner as to include a region I362 having a relatively high suitability degree in the suitability map I36. In one example, the region I362 is assumed to be the area I321 of the suitability map I32 illustrated in FIG. 14. The shape of the search position range I361 is not limited to a rectangular shape illustrated in FIG. 17, and may be set to a freely selected shape, as described above. Note that the search position range I361 may be set on the entirety of the suitability map I36.

The region I362 is not limited to one region as illustrated in FIG. 17, and is also assumed to be two or more regions. In this case, the search position range I361 may be set in such a manner as to include a part or all of the two or more regions.

As illustrated in FIG. 17, the processing circuitry 310 disposes a template T36 of a predetermined rotational angle, shape and dimensions at a search start position of the search position range I361. The shape of the template T36 is not limited to a rectangle illustrated in FIG. 17, and, may be a square or a freely selected shape composed of a combination of right-angled tetragons, as described above. In the case of disposing the template T36, the processing circuitry 310 calculates the evaluation value based on the total value of suitability degrees, by using the above-described calculation method.

If the evaluation value is calculated, the processing circuitry 310 changes the position of disposition of the template T36, and similarly calculates the evaluation value with respect to the disposition range. In this manner, in the search position range I361, the processing circuitry 310 calculates the evaluation value with respect to each position of disposition, while changing the position of disposition of the template T36. The processing circuitry 310 may continuously dispose the template T36 in such a manner as to move to all areas in the search position range I361, or may discretely dispose the template T36 in representative areas. If the processing circuitry 310 completes disposing at all scheduled positions in the search position range I361, the processing circuitry 310 selects, as the optimal position of disposition, the position of disposition that satisfies the optimal condition among the evaluation values corresponding to the positions of disposition. In the case of a single-stage search in which a single search range is a target, as illustrated in FIG. 17, it is expected that the optimal region of interest is an optimal solution, as long as the suitability map is accurate. In other words, it can be ensured that the region of interest does not become a non-optimal solution.

In the simple search process illustrated in FIG. 17, it is assumed that the rotational angle, shape and dimensions of the template T36 are fixed, but the present embodiment is not limited to this. In one example, the processing circuitry 310 calculates the evaluation value while changing the position of disposition and/or rotational angle with respect to each of templates with different combinations of shapes and dimensions, selects a plurality of disposition ranges corresponding to the templates, and determines, based on the selected disposition ranges, the optimal disposition range in which the evaluation value satisfies the optimal condition. This search process method is referred to as a multiple template method. Note that it is not necessary that both the shape and the dimensions are different, and either the shape or the dimensions may be identical.

FIG. 18 is a diagram schematically illustrating an example of processing of steps SC5 to SC8 using a multiple template method. The number of templates used in the multiple template method may be any number of two or more, and FIG. 18 exemplarily illustrates a case of two templates. As illustrated in an upper part of FIG. 18, the processing circuitry 310 uses two templates T371 and T372 having different combinations of a shape and dimensions. In one example, it is assumed that the shape of the template T371 is rectangular and the dimensions thereof are 80% of the default value, and the shape of the template T372 is square and the dimensions thereof are 100% of the default value.

The processing circuitry 310 disposes each of the two templates T371 and T372, individually, in a search position range I371 of a suitability map I37, calculates the evaluation value while changing the position of disposition and/or the rotational angle and fixing the shape and dimensions, searches the optimal disposition range by using the evaluation value, as described above, and selects the optimal disposition range. In addition, based on an optimal disposition range R371 of the template T371 and an optimal disposition range R372 of the template T372, the processing circuitry 310 determines a final version of the optimal disposition range R373. In one example, the processing circuitry 310 may select, as the final range R373, the disposition range having a higher evaluation value between the optimal disposition range R371 of the template T371 and the optimal disposition range R372 of the template T372. In another example, the processing circuitry 310 may select, as the final range R373, the disposition range acquired by weighted addition of evaluation values between the optimal disposition range R371 of the template T371 and the optimal disposition range R372 of the template T372. By parallel-processing the templates having multiple shapes and/or dimensions, the optimal disposition range can efficiently be searched.

It is assumed that the search process illustrated in FIG. 17 and FIG. 18 is a single-stage search having a single search range as a target. However, the present embodiment is not limited to this. In one example, the processing circuitry 310 may execute the calculation of the evaluation value and the determination of the optimal disposition range while changing in multiple stages the search range of the position of disposition, rotational angle, dimensions and/or shape. This search process method is referred to as a multi-stage search method.

FIG. 19 is a diagram schematically illustrating an example of processing of steps SC5 to SC8 using the multi-stage search method. The number of search stages in the multi-stage search method may be any number of two or more, and FIG. 19 exemplarily illustrates a case of three stages. As illustrated in an upper part of FIG. 19, in a first stage, the processing circuitry 310 disposes a template T381 on a suitability map I38. The position of disposition of the template T381 is limited to a global search position range I381. In one example, it is assumed that the dimension of each side of the search position range I381 is about 6 cm. It is assumed that the rotational angle, dimensions and shape are fixed to freely selected values. In the first stage, the processing circuitry 310 calculates the evaluation value while changing the position of disposition of the template T381 in the search position range I381 and fixing the rotational angle, dimensions and shape of the template T381, and determines the optimal disposition range by using the evaluation value, as described above.

In a second stage, it is assumed that the dimensions and shape are fixed to the same values as in the first stage. The position of disposition of a template T382 is limited to a local search position range I382 that includes the optimal disposition range of the first stage and is narrower than the global search position range I381. It is assumed that the dimension of each side of the search position range I382 is, for example, about 1 to 4 cm. In the case of rotating the right-angled tetragonal template T382, in order to secure the accuracy of the evaluation value, it is preferable that all sides of the template after disposition are parallel to any one of coordinate axes of the integral map I38. Specifically, the rotational angle is set to four rotational angles, namely 0°, 90°, 180°, and 270°. In the second stage, with respect to each of the four rotational angles, the processing circuitry 310 calculates the evaluation value while changing the position of disposition of the template T382 in the search position range I382 and fixing the dimensions and shape of the template T382, and determines the optimal disposition range by using the evaluation value, as described above.

In a third stage, the position of disposition of a template T383 is limited to an identical search position range I383 to the optimal disposition range of the second stage. The rotational angle is successively changed within a local angle range including the rotational angle of the optimal disposition range of the second stage. For example, if the rotational angle of the optimal disposition range of the second stage is 90°, the search range of the rotational angle of the third stage is set in the angle range of 45° to 135°. The search range of dimensions is set to, for example, a range of dimensions of 50% to 200%, and the shape is assumed to be three kinds, namely a rectangle, a square and a convex shape. In the third stage, with respect to the three shapes, the processing circuitry 310 calculates the evaluation value while changing the position of disposition of the template T383 in the search position range I383, changing the dimensions of the template T383 in the range of dimensions of 50% to 200% and changing the rotational angle in the angle range of 45° to 135° at a predetermined angular interval (for example, 10°), and determines the optimal disposition range by using the evaluation value, as described above. The optimal disposition range of the third stage is used as the final range. Identification data of the optimal disposition range is stored in the storage device 330. By using the multi-stage search method, it is expected that the optimal region of interest is the optimal solution, as long as the suitability map is accurate and the optimal solution is included in the optimal disposition range that is narrowed down in the stage before the final stage. In addition, compared to the single-stage search method, since the multi-stage search method narrows down the optimal disposition range in multiple stages, the optimal solution can be acquired in a short time.

If step SC8 is executed, the processing circuitry 310 outputs, by the output function 315, the identification data of the region of interest (hereinafter "optimal region of interest") corresponding to the optimal disposition range selected in step SC8 (step SC9). The identification data of the optimal region of interest is image data of the image area corresponding to the optimal disposition range, or position data of this image area.

If step SC9 is executed, the processing circuitry 310 displays, by the display control function 316, the identification data of the optimal region of interest that is output in step SC9 (step SC10). In step SC10, the processing circuitry 310 causes the display device 350 to display the display screen of the identification data of the optimal region of interest for the user's confirmation.

FIG. 20 is a diagram illustrating an example of a display screen IS31 of the identification data of the optimal region of interest. As illustrated in FIG. 20, for example, an infrared camera image IS311 relating to the crow is displayed on the display screen IS31. In the infrared camera image IS311, a crow area IS312 is extracted. A mark IS313 indicating the identification data of the optimal region of interest selected in step SC8 is rendered on the crow area IS312. By the disposition or the like of the mark IS313, the user can confirm whether the optimal region of interest is appropriate.

An OK button IS314 and an NG button IS315 may be displayed on the display screen IS31. The OK button IS314 is a GUI (Graphical User Interface) part for confirming the optimal region of interest. If the OK button IS314 is pressed via the input interface 370, the optimal region of interest is confirmed. The NG button IS315 is a GUI part for rejecting the optimal region of interest. If the NG button IS315 is pressed via the input interface 370, the processing circuitry 310 rejects the optimal region of interest. In this case, the processing circuitry 310 may repeat the process of steps SC5 to SC7 once again from default values. Alternatively, the processing circuitry 310 may correct the optimal region of interest by changing the position of disposition, rotational angle, dimensions and/or shape of the mark IS313 on the display screen IS31. After the correction, if the OK button IS314 is pressed via the input interface 370, the processing circuitry 310 confirms the image area indicated by the mark IS313 as the optimal region of interest. The identification data of the confirmed optimal region of interest is stored in the storage device 330.

If the OK button IS314 is pressed, the processing circuitry 310 ends the region-of-interest search process illustrated in FIG. 13. Thereafter, the identification data of the optimal region of interest is transferred to a freely selected image processing apparatus by the processing circuitry 310. Then, the image processing apparatus performs an imaging process on the optimal region of interest corresponding to the received identification data. Since the imaging process is performed on the optimal region of interest, it is expected that imaging process is accurately performed on a desired area.

Note that the region-of-interest search process illustrated in FIG. 13 is merely an example, and the present embodiment is not limited to this, and various omissions, additions and/or changes to the processing can be made without departing from the spirit of the invention. In one example, the template acquisition step (SC1) may be executed in any order before the template disposing step (SC5). In another example, the display step (SC10) of the identification data of the optimal region of interest can be omitted.

In the region-of-interest search process illustrated in FIG. 13, it is assumed that the region of interest, which is the image processing target, is searched. However, the present embodiment is not limited to this. In one example, the embodiment is applicable to any process of searching a region of interest included in a face image by using a template. As such processes, the embodiment is applicable to a face recognition algorithm by Viola et al. (Viola, P.; Jones, M. (2001). "Rapid object detection using a boosted cascade of simple features". Proceedings of the 2001 IEEE Computer Society Conference on Computer Vision and Pattern Recognition. CVPR 2001) or to image recognition for object detection or the like. In addition, the region of interest may be searched as an imaging target by the imaging apparatus 400. In this case, the imaging apparatus 400 can set an imaging area, based on the identification data of the optimal region of interest, and can perform imaging with the imaging area being set as a target.

Note that in order to dispose the rotated template on the integral map in the case of changing the rotational angle of the template, it is necessary to rotate the search target data and calculate the integral map thereof. In this calculation, for example, instead of setting the horizontal direction at +1, the horizontal direction is set at +1 and the vertical direction is set at -1, and instead of setting the vertical direction at +1, the horizontal direction is set at -1 and the vertical direction is set at +1. Thereby, an integral map that is rotated over 45 degrees is generated on the space in which the spatial distance is scaled with $\sqrt{2}$ times magnification, and a search can be performed on the integral map. In this case, at a time of rotating the template, it is necessary to include a correction calculation for the spatial distance. Note that this method can be applied to an angle other than 45 degrees, for example, in such a manner that, instead of setting the horizontal direction at +1, the horizontal direction is set at +1 and the vertical direction is set at -2 (the spatial distance is scaled with $\sqrt{5}$ times magnification). In addition, this method can be applied to a freely chosen angle by using a rounding process of the position.

It is assumed that the image according to the present embodiment is the infrared camera image, but the embodiment is also applicable to a medical image. In a case where an abnormal region such as a tumor in the medical image is set as an imaging target, a processed image can be acquired by performing segmentation for classifying the abnormality. In addition, as the source image, use may be made of, for example, data that is not displayed normally as an image, such as a coil sensitivity map or a shimming map used in an MRI apparatus. The coil sensitivity map is an image representing sensitivity to a spatial position of a transmitter coil or a receiver coil, and the shimming map is an image representing a spatial distribution of shimming values that represent an error from a reference frequency. In the case where the medical image is used as the source image, the pixel information means the pixel value for each pixel, a segmentation value representing a segmentation result, a shimming value representing an error from a reference frequency, a signal value, and/or a gradient of one or more data channels based on the signal value.

According to some embodiments described above, the integral data string processing apparatus 300 includes the processing circuitry 310. The processing circuitry 310 acquires the template for searching the region of interest. Based on the pixel information of each pixel, the processing circuitry 310 generates the suitability map representing the suitability degree as the region of interest for each pixel. The processing circuitry 310 generates the integral map of the suitability map. The processing circuitry 310 calculates, for each disposition range of the template to the suitability map, the evaluation value as the region of interest of the template by utilizing the integral map, and searches the specific disposition range in which the evaluation value satisfies a separately determined condition. The processing circuitry 310 outputs the identification data of the region of interest corresponding to the specific disposition range.

According to the above-described configuration, the evaluation value as the region of interest of the template is acquired by utilizing the integral map of the suitability map, and the disposition range of the template is searched based on the evaluation value. Thus, the region of interest can be acquired in a short time and with a light load, while decreasing the possibility of leading to a local solution. In addition, since the processing circuitry 310 acquires the suitability map by utilizing the image information of the segmentation result or the like, the processing circuitry 310 can reduce the possibility that the region of interest is set on an undesired region.

According to at least one of the above-described embodiments, an appropriate region of interest can be acquired under a restriction of a short processing time.

(Third Embodiment)

In the case of changing the rotational angle of the template in the region-of-interest search process according to the second embodiment, it is assumed that the template after rotation is disposed on the suitability map. A processing circuitry 310 according to a third embodiment may dispose a template, with respect to which one-to-one conversion has not been executed, on a suitability map after one-to-one conversion. Hereinafter, an integral data string processing apparatus 300 according to the third embodiment is described. In the description below, structural elements having substantially the same functions as in the second embodiment are denoted by like reference signs, and an overlapping description is given only where necessary.

FIG. 21 is a diagram exemplarily illustrating a functional configuration of a search function 314 according to the third embodiment. The search function 314 according to the third embodiment calculates, for each disposition range of a template to an input data string after one-to-one conversion, an evaluation value of the template by utilizing an integral data string generated by the integral map generation function 313, and searches a specific disposition range in which the evaluation value satisfies a separately determined condition. As illustrated in FIG. 21, the search function 314 includes an input function 3141, a generation function 3142, a disposing function 3143, a calculation function 3144, and a specifying function 3145.

By the input function 3141, the processing circuitry 310 inputs an input data string that is a data string of two or more dimensions. As the input data string, use is made of image data such as a two-dimensional or three-dimensional source image or a suitability map. The input function 3141 corresponds to an input unit.

By the generation function 3142, the processing circuitry 310 generates a converted input data string by applying separately determined one-to-one conversion to the input data string that is input by the input function 3141. As the separately determined one-to-one conversion, for example, affine transformation including a change of a position of disposition, a rotational angle and/or dimension is adopted. The generation function 3142 corresponding to a first generation unit.

By the disposing function 3143, the processing circuitry 310 disposes a template on the converted input data string generated by the generation function 3142. A data area in the converted input data string, which is occupied by the template disposed on the converted input data string, is referred to as a disposition range. The disposing function 3143 corresponds to a disposing unit.

By the calculation function 3144, the processing circuitry 310 calculates, by utilizing an integral data string, an integral value of data values of the input data string in the disposition range of the template disposed on the converted input data string. Here, the integral data string means an integral map that is a data string of the integral value, and that is generated by the integral map generation function 313. By the integral map generation function 313, the processing circuitry 310 generates an integral data string that is a data string acquired by integrating the converted input data string in one or more dimensions. For example, the processing circuitry 310 generates an integral data string that is a data string acquired by integrating the converted input data string in all dimensions of the converted input data string. Note that the processing circuitry 310 may generate an integral data string that is a data string acquired by integrating the converted input data string in some of the dimensions of the converted input data string. The integral map generation function 313 corresponds to a second generation unit.

By the specifying function 3145, the processing circuitry 310 searches a specific disposition range in which the evaluation value calculated by the calculation function 3144 satisfies a separately determined condition. This condition is, like the second embodiment, an optimal condition for an optimal disposition range to be selected, and, for example, is set to be that the evaluation value is an optimal value. The specifying function 3145 corresponds to a specifying unit.

Next, the details of the integral data string processing apparatus 300 according to the third embodiment are described. Hereinafter, the integral data string processing is described by taking a region-of-interest search process as a concrete example. It is assumed that the input data string is a suitability map, and the one-to-one conversion is a rotation.

FIG. 22 is a diagram illustrating a processing procedure of the region-of-interest search process according to the third embodiment. The processing circuitry 310 first executes the template acquisition step (SC1), the image information acquisition step (SC2) and the suitability map generation step (SC3) of FIG. 13.

If step SC3 is executed, the processing circuitry 310 inputs, by the input function 3141, the suitability map generated in step SC3 (step SD1). By the input of the suitability map, the suitability map is taken in a work area of the processing circuitry 310. The suitability map is an example of the input data string.

If step SD1 is executed, the processing circuitry 310 reversely rotates the suitability map that is input in step SD1, by the generation function 3142 (step SD2). The reverse rotation is an example of the one-to-one conversion. If step SD2 is executed, the processing circuitry 310 generates, by the integral map generation function 313, the integral map, based on the reversely rotated suitability map generated in step SD2 (step SD3). The reversely rotated suitability map is an example of the converted input data string. If step SD3 is executed, the processing circuitry 310 disposes, by the disposing function 3143, the template acquired in step SC1 on the reversely rotated suitability map generated in step SD2 (step SD4). If step SD4 is executed, the processing circuitry 310 calculates, by the calculation function 3144, the integral value in the disposition range of the template by utilizing the integral map, and calculates the evaluation value, based on the integral value (step SD5). If step SD5 is executed, the processing circuitry 310 determines, by the disposing function 3143, whether the position of disposition, dimensions and/or shape is changed (step SD6). In step SD6, the processing circuitry 310 determines whether an ending condition for the change of the position of disposition, dimensions, and/or shape is satisfied or not. The ending condition may be set to be such a condition that all search ranges of the position of disposition, dimensions, and/or shape are completed, that the evaluation value has reached a predetermined value, or that the number of times of change has reached a predetermined number. If the ending condition is not satisfied, the processing circuitry 310 determines that the position of disposition, dimensions, and/or shape is changed. If the ending condition is satisfied, the processing circuitry 310 determines that the position of disposition, dimensions, and/or shape is not changed.

If it is determined in step SD6 that the position of disposition, dimensions and/or shape is not changed (step SD6: NO), the processing circuitry 310 determines, by the generation function 3142, whether or not to change the rotational angle (step SD7). Specifically, the processing circuitry 310 determines whether the process of steps SD2 to SD6 has been executed for all rotational angles of the search angle range. If the process of steps SD2 to SD6 has not been executed for all rotational angles of the search angle range, the processing circuitry 310 determines that the rotational angle is changed. In this case, the processing circuitry 310 executes the process of steps SD2 to SD6 for a non-processed rotational angle of the search angle range. In this manner, steps SD2 to SD7 are repeated until there remains no non-processed rotational angle.

In addition, if it is determined in step SD7 that the rotational angle is not changed (step SD7: NO), the processing circuitry 310 determines, by the specifying function 345, the optimal disposition range that satisfies the optimal condition (step SD8). As in the second embodiment, the optimal condition may be typically set to be such a condition that the evaluation value calculated in step SC6 is highest. In this case, the disposition range with the highest evaluation value is determined as the optimal disposition range.

If step SD8 is executed, the output step (SC9) of the identification data of the optimal region of interest and the identification data display step (SC10) illustrated in FIG. 13 are executed. Thereby, the region-of-interest search process according to the third embodiment is completed.

Here, referring to FIG. 23, steps SD1 to SD8 are described in detail. FIG. 23 is a diagram schematically illustrating a processing procedure of steps SD1 to SD8. As illustrated in an uppermost stage of FIG. 23, in step SD1, the processing circuitry 310 first disposes a suitability map I391 generated in step SC3 on a world coordinate system (absolute coordinate system) W31. The world coordinate system W31 is an image processing space defined by an orthogonal coordinate system specified by an abscissa axis X and an ordinate axis Y. In the world coordinate system W31, lattice points (pixels) are arrayed along orthogonal three axes. The suitability map I391 is disposed such that the abscissa axis is parallel to the X axis and the ordinate axis is parallel to the Y axis. The suitability map I391 includes an area I392 having a high suitability degree. It is expected that an optimal region of interest is disposed in the optimal range of the area I392.

Next, as illustrated in a second stage of FIG. 23, the processing circuitry 310 reversely rotates the suitability map I391 in the world coordinate system W31. In the region-of-interest search process illustrated in FIG. 13, the template is rotated in the forward direction. In the search process according to the third embodiment, the suitability map is rotated in the reverse direction (reversely rotated). The absolute value of the rotational angle of the reverse rotation is equal to the absolute value of the rotational angle of the template with respect to the suitability map in the region-of-interest search process. For example, FIG. 23 exemplarily illustrates a case of reverse rotation over 45°. The processing circuitry 310 allocates, to the respective lattice points of the world coordinate system W31, the suitability degrees of the corresponding pixels of the suitability map I391 after rotation. In a case where the lattice points of the world coordinate system W31 do not coincide with the positions of the pixels of the suitability map I391 after rotation, the suitability degrees allocated to the respective lattice points may be calculated by applying a super-resolution technique, such as by displacing the suitability map I391 by a 0.5 pixel.

Next, as illustrated in a third stage of FIG. 23, the processing circuitry 310 generates an integral map I393 in the world coordinate system W31, based on the suitability map I391 after reverse rotation. The integral map I393 is disposed such that the abscissa axis is parallel to the X axis and the ordinate axis is parallel to the Y axis. The dimensions of the integral map I393 are set in such a manner as to include the suitability map I391. For example, the integral map I393 is set in such a manner as to circumscribe the suitability map I391 after reverse rotation. The processing circuitry 310 calculates an integral value of a plurality of suitability degrees corresponding to a plurality of pixels included in a right-angled tetragonal area I394 having an origin P390 of the integral map I393 as the upper left end and having a target pixel P391 as the lower right end, and allocates the calculated integral value to the target pixel P391. The right-angled tetragonal area I394 is disposed such that the abscissa axis is parallel to the X axis and the ordinate axis is parallel to the Y axis. The integral map I393 is generated by performing this process for all the pixels included in the integral map I393.

As illustrated in the third stage of FIG. 23, the suitability map I391 after reverse rotation is two-dimensional image data defined by the abscissa axis (X axis) and the ordinate axis (Y axis). The processing circuitry 310 generates the integral map I393 by the integration of the suitability map I391 after reverse rotation, in all dimensions of the suitability map I391 after reverse rotation, that is, in both the X axis and the Y axis. Note that the processing circuitry 310 may generate the integral map I393 by the integration in one of the X axis and the Y axis of the suitability map I391 after reverse rotation.

Next, as illustrated in a fourth stage of FIG. 23, a template T39 is disposed in a search area I394 that is set in the suitability map I391. The template T39 is disposed such that the abscissa axis is parallel to the X axis and the ordinate axis is parallel to the Y axis. The template T39 is disposed without rotation relative to the suitability map I391 that was rotated in the reverse direction as described above, and thereby the template T39 rotates in the forward direction relative to the suitability map I391. Thereafter, the processing circuitry 310 repeats the calculation of the evaluation value in the disposition range and the change of the position of disposition, dimensions and/or shape, and searches the optimal disposition range of the template T39, based on the evaluation value. By scanning the reversely rotated suitability map I391 by the unrotated template T39, it becomes possible to scan the unrotated suitability map in a nonparallel and nonperpendicular manner to the coordinate axes by the template T39. In other words, it becomes possible to execute a process equivalent to a process scanning the unrotated suitability map by the forwardly rotated template.

As illustrated in a fifth stage of FIG. 23, in a case where the optimal disposition range is specified, the processing circuitry 310 disposes the template T39 in the optimal disposition range of the unrotated suitability map I391. The template T39 is forwardly rotated by the above-described rotational angle.

The search process illustrated in FIG. 22 is merely an example, and the present embodiment is not limited to this, and various omissions, additions and/or changes to the processing can be made without departing from the spirit of the invention. In one example, the template acquisition step (SC1) may be executed in any order before the template disposing step (SD4). In another example, the display step (SC10) of the identification data of the optimal region of interest can be omitted.

The search process exemplarily illustrated in FIG. 23 is merely an example, and the present embodiment is not limited to this. For example, it is possible to calculate the evaluation value while changing the position of disposition, dimensions and/or shape with respect to each of a plurality of suitability maps with different rotational angles after reverse rotation, select a plurality of disposition ranges corresponding to the suitability maps after reverse rotation, and to determine an optimal disposition range in which the evaluation value satisfies the optimal condition, based on the selected disposition ranges. This search method is referred to as a multi-thread method.

FIG. 24 is a diagram schematically illustrating an example of a search process using the multi-thread method. The number of rotational angles used in the multi-thread method, or, in other words, the number of suitability maps after reverse rotation, may be any number of two or more. In the example of the search process illustrated in FIG. 24, the search angle range of the rotational angles is from 0 degrees to 85 degrees, and a search is executed from 0 degrees in units of 5 degrees. Specifically, the number of rotational angles at which the search is actually executed is 18, namely 0 degrees, 5 degrees, 10 degrees,..., 85 degrees. The numeral "n" of the suitability map IIn after reverse rotation illustrated in FIG. 24 is the number of the suitability map after reverse rotation, and takes a value from 0 corresponding to 0 degrees to 18 corresponding to 85 degrees.

As illustrated in an upper part of FIG. 24, the processing circuitry 310 generates 18 suitability maps IIn after rotation, and disposes the generated suitability maps IIn after reverse rotation on a world coordinate system W3n. Then, the processing circuitry 310 disposes an unrotated template T3n on the suitability map IIn after reverse rotation. Like the suitability map after reverse rotation, the numeral "n" of the template T3n is the number of the template. The dimensions and the shapes of the templates T3n can be freely set. The dimensions and the shapes of the templates T3n can be set to identical values, or may be set to different values.

The processing circuitry 310 disposes the 18 templates T3n individually on the suitability maps IIn after reverse rotation, calculates evaluation values while changing the positions of disposition and fixing the shapes and dimensions, searches the optimal disposition ranges by using the evaluation values, as described above, and specifies optimal disposition ranges Bn. Like the suitability map after reverse rotation, the numeral "n" of the optimal disposition range Bn is the number of the optimal disposition range. Thereby, the optimal disposition ranges can be searched in parallel with respect to the 18 rotational angles.

In addition, the processing circuitry 310 determines a final version of the optimal position range B0, based on the optimal disposition ranges Bn relating to the suitability maps IIn after reverse rotation. For example, the processing circuitry 310 may select, as the final range B0, the disposition range with the highest evaluation value among the optimal disposition ranges Bn of the suitability maps IIn after reverse rotation. The optimal disposition range B0 is forwardly rotated by the rotational angle corresponding to the optimal disposition range B0, relative to the unrotated suitability map I0 disposed on the world coordinate system W30.

According to the multi-thread method, since the search process can be performed in parallel for a plurality of suitability maps after reverse rotation with different angles, the optimal disposition range can efficiently be searched. Note that the determination method of the final range is not limited to the above. For example, the processing circuitry 310 may determine, as the final range, the disposition range acquired by performing weighted addition, with the evaluation values, for the optimal disposition ranges of the suitability maps after reverse rotation.

Next, a description is given of one pattern of the changes of the position of disposition of the template, the dimensions of the template, and the rotational angle of the input data string in the search process illustrated in FIG. 22. The processing circuitry 310 searches a specific disposition range (optimal disposition range) while changing the position of disposition of the template, the dimensions of the template, and the rotational angle of the input data string. Here, each time the processing circuitry 310 changes the rotational angle of the input data string, the processing circuitry 310 searches the optimal disposition range by changing the position of disposition of the template with respect to the combination, which is selected by a separately determined method, of the dimensions of the template. As the separately determined method, use may be made of any one of a first-dimensional search, a second-dimensional search, a third-dimensional complete search, a multi-stage search and a diamond search in regard to the position, and use may be made of a first-dimensional search, a second-dimensional search, a third-dimensional complete search and a multi-stage search in regard to the dimensions.

FIG. 25 is a diagram illustrating a concrete example relating to a part of the search process illustrated in FIG. 22. FIG. 25 illustrates a concrete example of steps SD3 to SD7 of FIG. 22. The concrete example illustrated in FIG. 25 is an example in which an imaging area of MR spectroscopy is set on a tumor region included in an MR image. An optimal disposition range in the tumor region is used as the imaging area. Note that the region of interest of the above-described embodiment corresponds to the imaging area.

As illustrated in FIG. 25, a suitability map and default parameters are input to the processing circuitry 310. The parameters relate to nine kinds of parameters, namely a position of disposition (Vx, Vy, Vz), dimensions (Rx, Ry, Rz), and a rotational angle ($\alpha$, $\beta$, $\gamma$), which are search targets. The default parameters are preset at freely selected values. It is assumed that the shape of the template is fixed in the search process of FIG. 25.

In the case where the suitability map and the default parameters are input, the processing circuitry 310 generates an integral map with respect to the rotational angle (α, β, γ) by the integral map generation function 313 (step SE1). The generation method of the integral map is the same as in step SD3 of FIG. 22. Note that (α, β, γ) may be a rotational angle of reverse rotation, or may be treated as a normal rotational angle, and a correction corresponding to this rotational angle may finally be made.

If step SE1 is executed, the processing circuitry 310 searches the position of disposition (Vx, Vy, Vz) with respect to the parameters (Rx, Ry, Rz, α, β, γ) (step SE2). This search of the position of disposition may be a one-dimensional search, or a two-dimensional search in which a combination of two is changed, or a three-dimensional all-candidate search (full search), or a method in which a high-speed search method is executed in a three-dimensional space, such as a multi-stage search (Reoxiang Li, Bing Zeng and M. L. Liou, "A new three-step search algorithm for block motion estimation," in IEEE Transactions on Circuits and Systems for Video Technology, vol. 4, no. 4, pp. 438-442, Aug. 1994, doi: 10.1109/76.313138.) or a diamond search (Shan Zhu and Kai-Kuang Ma, "A new diamond search algorithm for fast block-matching motion estimation," in IEEE Transactions on Image Processing, vol. 9, no. 2, pp. 287-290, Feb. 2000, doi: 10.1109/83.821744.). If step SE2 is executed, the processing circuitry 310 determines whether all dimensions (Rx, Ry, Rz) have been processed (step SE3). If it is determined that all dimensions (Rx, Ry, Rz) have not been processed, the processing circuitry 310 calculates the evaluation value while changing the dimensions (Rx, Ry, Rz) and fixing the rotational angle (α, β, γ) of the integral map generated in step SE1. The evaluation value is stored in the storage device 330 with respect to each of combinations of parameters (Vx, Vy, Vz, Rx, Ry, Rz, α, β, γ). In the repetition of steps SE2 and SE3, a one-dimensional search in which only one of the three dimension parameters (Rx, Ry, Rz) is changed, or other search methods, such as a two-dimensional search in which a combination of two is changed, a three-dimensional all-candidate search (full search), or a multi-stage search may be used.

In step SE3, if it is determined that all dimensions (Rx, Ry, Rz) have been processed, the processing circuitry 310 determines whether all rotational angles (α, β, γ) have been processed (step SE4). If it is determined that all rotational angles (α, β, γ) have not been processed, the processing circuitry 310 generates the integral map by varying the rotational angles (α, β, γ), and repeats steps SE2 to SE4 with respect to the changed integral map. In the repetition of steps SE1 to SE4, use may be made of a one-dimensional search in which only one of the three rotational angles (α, β, γ) is changed, or other search methods, such as a two-dimensional search in which a combination of two is changed, a three-dimensional all-candidate search (full search), or a multi-stage search. If it is determined that all rotational angles (α, β, γ) have been processed, the search with respect to all parameters (Vx, Vy, Vz, Rx, Ry, Rz, α, β, γ) is ended. In addition, the processing circuitry 310 determines the parameter (Vx, Vy, Vz, Rx, Ry, Rz, α, β, γ) having the highest evaluation value as the optimal disposition range.

As described above, in the search process illustrated in FIG. 25, the processing circuitry 310 can comprehensively search the parameters (Vx, Vy, Vz, Rx, Ry, Rz, α, β, γ) by changing the position of disposition (Vx, Vy, Vz), the dimensions (Rx, Ry, Rz), and the rotational angle (α, β, γ) in order.

The integral data string processing apparatus 300 according to the third embodiment is assumed to search the optimal region of interest. However, like the third embodiment, the third embodiment is not limited to this, and is applicable to any process of searching an optimal disposition range included in the input data string by using a template. For example, the third embodiment is also applicable to the above-described face recognition algorithm by Viola et al., and the image recognition for object detection or the like. In addition, in the third embodiment, the integral value of the data values of the input data string in the disposition range of the template disposed on the converted input data string after one-to-one conversion may be calculated by utilizing the integral data string based on the converted input data string, and it is not always necessary to search the optimal disposition range by utilizing the integral value.

According to some embodiments described above, the integral data string processing apparatus 300 includes the processing circuitry 310. The processing circuitry 310 inputs an input data string that is a data string of two or more dimensions. The processing circuitry 310 generates a converted input data string by applying separately determined one-to-one conversion to the input data string. The processing circuitry 310 generates an integral data string that is a data string acquired by integrating the converted input data string in one or more dimensions. The processing circuitry 310 calculates, by utilizing the integral data string, an integral value of data values of the input data string in the disposition range of the template disposed on the converted input data string.

According to the above-described configuration, even in the case where the template is not disposed in parallel to and perpendicular to the coordinate axes of the input data string, the calculation of the integral value of the data string of the input data string can be implemented by utilizing the integral data string.

According to at least one of the above-described embodiments, the convenience of the integral image processing can be improved.

The term "processor" used in the above description means, for example, circuitry such as a CPU, a GPU, an application specific integrated circuitry (ASIC), or a programmable logic device (for example, a simple programmable logic device (SPLD), a complex programmable logic device (CPLD), and a field programmable gate array (FPGA)). The processor implements functions by reading and executing a program stored in the storage circuitry. Note that, instead of storing the program in the storage circuitry, such a configuration may be adopted that the program is directly assembled in the circuitry of the processor. In this case, the processor implements functions by reading and executing the program assembled in the circuitry of the processor. On the other hand, in a case where the processor is, for example, an ASIC, the functions are directly assembled as logic circuitry in the circuitry of the processor, instead of the program being stored in the storage circuitry. Note that the processors in the embodiments are not limited to cases where each processor is constituted as single circuitry, and a plurality of independent circuities may be combined to constitute one processor and to implement functions thereof. Furthermore, a plurality of constituent elements in FIG. 1 may be integrated into one processor, and the processor may implement the functions thereof.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

**1.** An imaging area output apparatus comprising a processing circuitry configured to:

acquire a template for searching an imaging area;
generate, based on pixel information of each of pixels, an appropriateness map representing an appropriateness degree as the imaging area for each of the pixels;
generate an integral map of the appropriateness map;
calculate an evaluation value as the imaging area of the template by utilizing the integral map with respect to each of disposition ranges of the template to the appropriateness map, and search a specific disposition range in which the evaluation value satisfies a separately determined condition; and
output identification data of the imaging area corresponding to the specific disposition range.

**2.** The imaging area output apparatus of claim 1, wherein the pixel value includes a segmentation value representing a segmentation result for each of the pixels, a shimming value representing an error from a reference frequency, a signal value, and/or a monochromatic or color gradient based on the signal value.

**3.** The imaging area output apparatus of claim 1, wherein the processing circuitry is configured to:

calculate a total value of appropriateness degrees allocated to the pixels included in the disposition range of the template, by utilizing the integral map; and
calculate the evaluation value, based on the total value.

**4.** The imaging area output apparatus of claim 3, wherein the processing circuitry is configured to calculate the evaluation value, based on a correction value obtained by correcting the total value by a size of the template.

**5.** The imaging area output apparatus of claim 1, wherein the processing circuitry is configured to change the disposition range of the template with respect to the appropriateness map by varying a combination of the position of disposition, a rotational angle, dimensions, and/or a shape of the template with respect to the appropriateness map.

**6.** The imaging area output apparatus of claim 1, wherein the processing circuitry is configured to calculate the evaluation value with respect to the position of disposition while changing the position of disposition of the template in a search position range that is set on the appropriate degree map.

**7.** The imaging area output apparatus of claim 1, wherein the processing circuitry is configured to:

calculate the evaluation value while changing a position of disposition and/or a rotational angle with respect to each of the templates with different combinations of shapes and dimensions, and select a plurality of disposition ranges corresponding to the templates; and
determine, based on the selected disposition ranges, the specific disposition range in which the evaluation value satisfies the condition.

**8.** The imaging area output apparatus of claim 1, wherein the processing circuitry is configured to execute calculation of the evaluation value and selection of the specific disposition range while changing in multiple stages a search range of the position of disposition, the rotational angle, the dimensions and/or the shape.

**9.** The imaging area output apparatus of claim 1, wherein the processing circuitry is configured to:

rotate the appropriateness map at a plurality of rotational angles in an absolute coordinate system;
generate the integral map of the rotated appropriateness map in the absolute coordinate system with respect to each of the rotational angles;
dispose the template on the rotated appropriateness map in such a manner that at least one side of the template is parallel to any one of coordinate axes of the absolute coordinate system, and calculate the evaluation value of the template in the disposition range; and
select the specific disposition range in which the evaluation value satisfies the condition.

**10.** The imaging area output apparatus of claim 1, wherein the processing circuitry is configured to apply to the evaluation value a penalty for making smaller the evaluation value as a difference between a length of each of axes of the template and a desired length becomes larger.

**11.** The imaging area output apparatus of claim 1, wherein the processing circuitry is configured to:

input an input data string that is a data string of two or more dimensions;
generate a converted input data string by applying separately determined one-to-one conversion to the input data string;
generate an integral data string that is a data string acquired by integrating the converted input data string in one or more dimensions; and
calculate, by utilizing the integral data string, an integral value of data values of the input data string in the disposition range of the template disposed on the converted input data string.

**12.** The imaging area output apparatus of claim 11, wherein the processing circuitry is configured to:

calculate an evaluation value based on the integral value, by utilizing the integral data string with respect to each of the disposition ranges; and
search a specific disposition range in which the evaluation value satisfies a separately determined condition.

**13.** The imaging area output apparatus of claim 12, wherein the processing circuitry is configured to:

generate the converted input data string acquired by reversely rotating the input data string by a predetermined rotational angle, thereby to search the specific disposition range by using the template that is forwardly rotated by the predetermined rotational angle relative to the input data string; and
dispose the template, which is unrotated, on the converted input data string.

**14.** The imaging area output apparatus of claim 13, wherein the processing circuitry is configured to:

generate the converted input data strings that are reversely rotated by a plurality of rotational angles; and
search the specific disposition range with respect to each of the converted input data strings, and specify a disposition range in which the evaluation value is highest among the specific disposition ranges of the converted input data strings.

**15.** The imaging area output apparatus of claim 11, wherein the one-to-one conversion is affine transformation.

**16.** The imaging area output apparatus of claim 11, wherein the processing circuitry is configured to generate the integral data string that is a data string acquired by integrating the converted input data string in all dimensions of the converted input data string.

**17.** The imaging area output apparatus of claim 11, wherein the input data string is image data.

**18.** The imaging area output apparatus of claim 13, wherein the processing circuitry is configured to:

search the specific disposition range while changing a position of disposition of the template, dimensions of the template, and a rotational angle of the input data string, change, each time the rotational angle of the input data string is changed, the position of disposition of the template with respect to a combination selected by a separately determined method of the dimensions of the template, and search the specific disposition range; and
the separately determined method uses a method of any one of a first-dimensional search, a second-dimensional search, a third-dimensional complete search, a multi-stage search and a diamond search in regard to a position, and uses a method of any one of a first-dimensional search, a second-dimensional search, a third-dimensional complete search and a multi-stage search in regard to dimensions.

**19.** An imaging area output method comprising:

acquiring a template for searching an imaging area;
generating, based on pixel information of each of pixels, an appropriateness map representing an appropriateness degree as the imaging area for each of the pixels;
generating an integral map of the appropriateness map;
calculating an evaluation value as the imaging area of the template by utilizing the integral map with respect to each of disposition ranges of the template to the appropriateness map, and searching a specific disposition range in which the evaluation value satisfies a separately determined condition; and
outputting identification data of the imaging area corresponding to the specific disposition range.

**20.** An imaging apparatus comprising an imaging unit configured to perform imaging on an imaging area corresponding to identification data of the imaging area that is output from the imaging area output apparatus of claim 1.

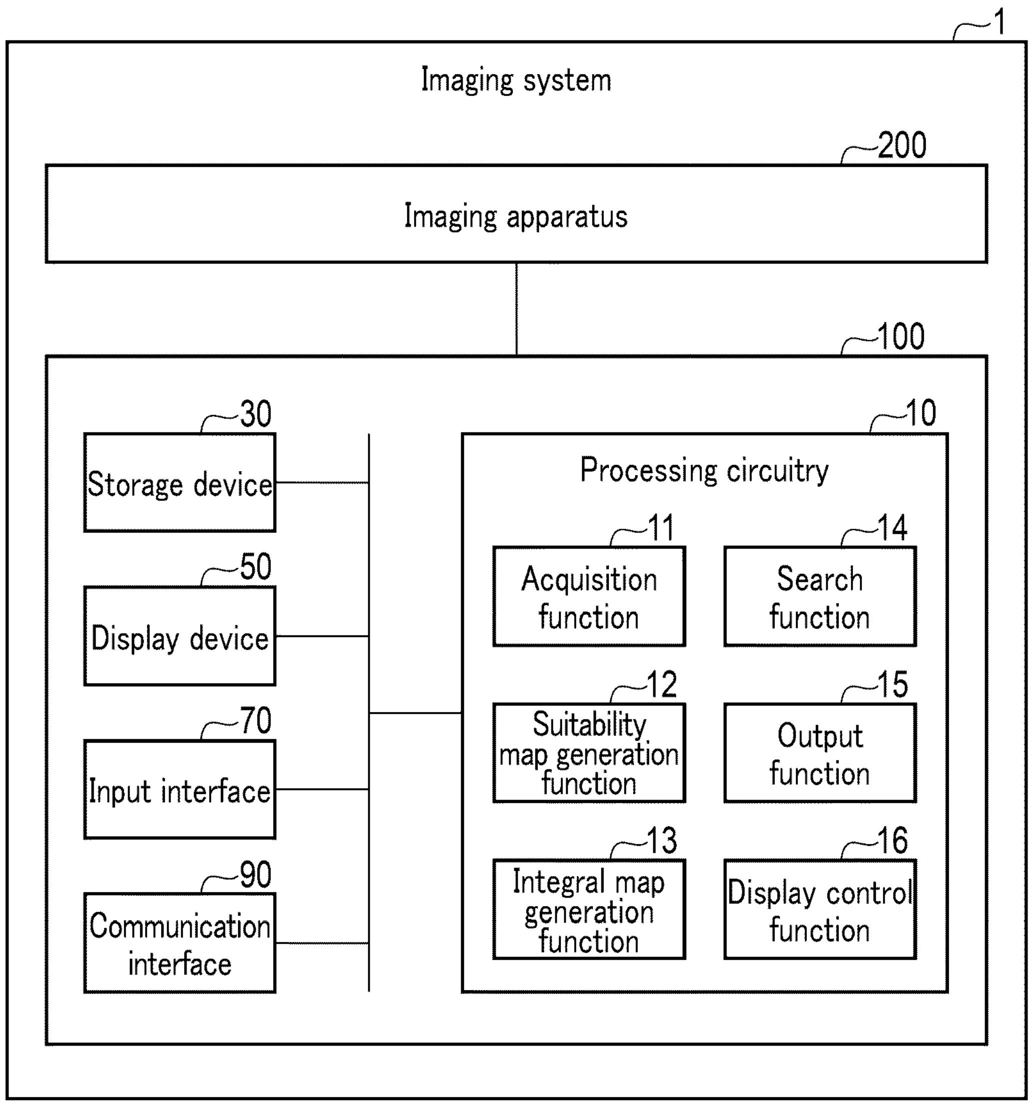
1
Imaging system
200
Imaging apparatus
100
30
Storage device
50
Display device
70
Input interface
90
Communication interface
10
Processing circuitry
11
Acquisition function
14
Search function
12
Suitability map generation function
15
Output function
13
Integral map generation function
16
Display control function

F I G. 1

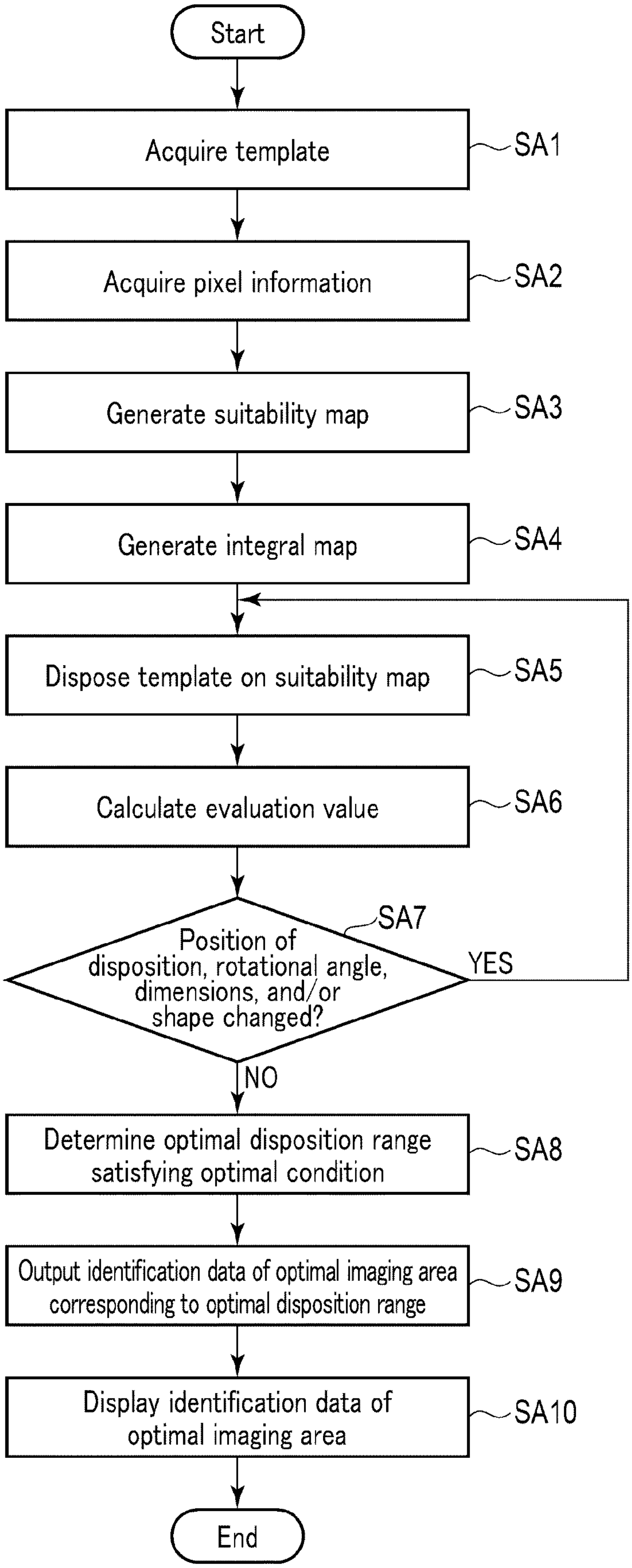
Start
Acquire template
SA1
Acquire pixel information
SA2
Generate suitability map
SA3
Generate integral map
SA4
Dispose template on suitability map
SA5
Calculate evaluation value
SA6
SA7
Position of disposition, rotational angle, dimensions, and/or shape changed?
YES
NO
Determine optimal disposition range satisfying optimal condition
SA8
Output identification data of optimal imaging area corresponding to optimal disposition range
SA9
Display identification data of optimal imaging area
SA10
End

F I G. 2

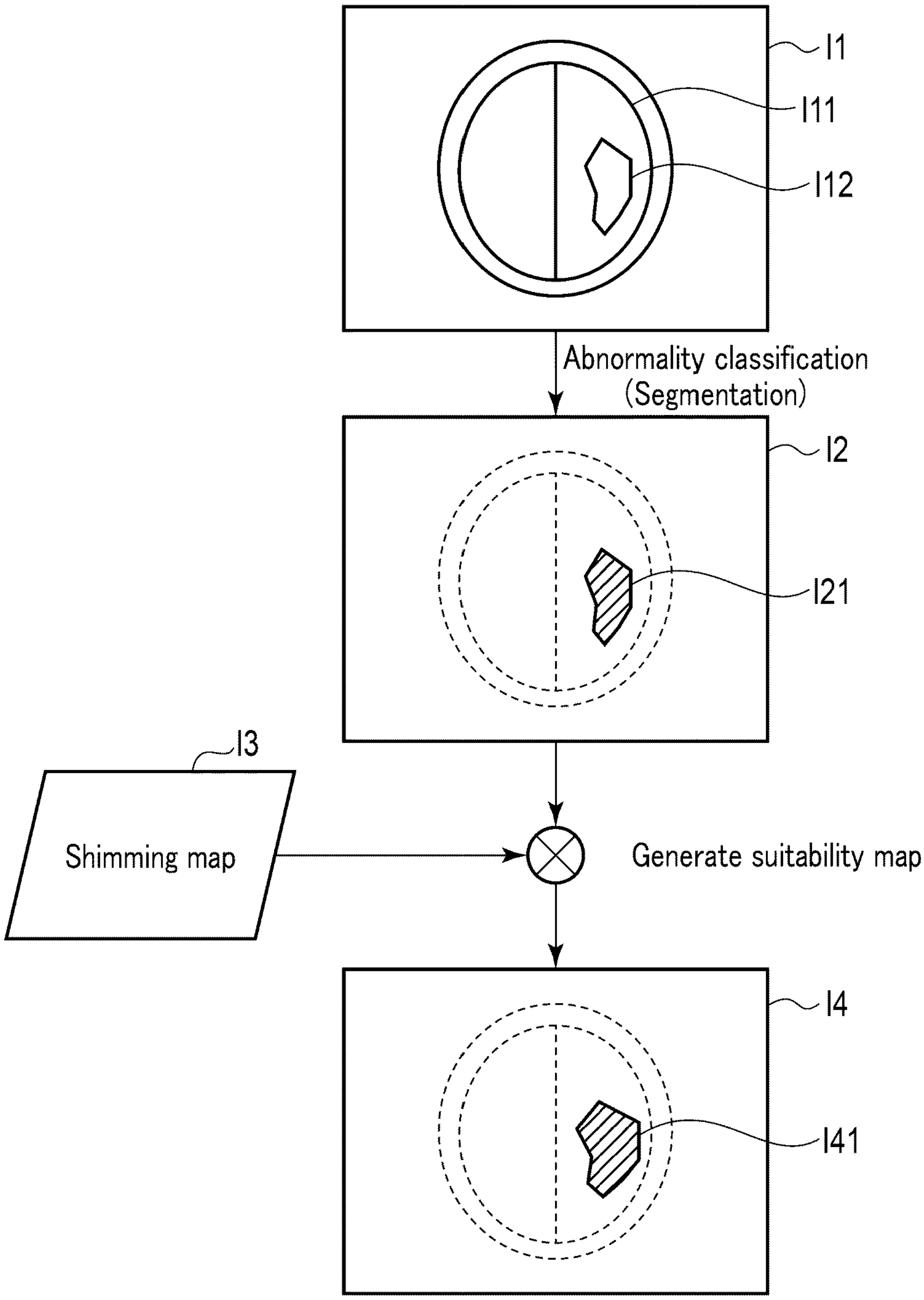
I1
I11
I12
Abnormality classification
(Segmentation)
I2
I21
I3
Shimming map
Generate suitability map
I4
I41

F I G. 3

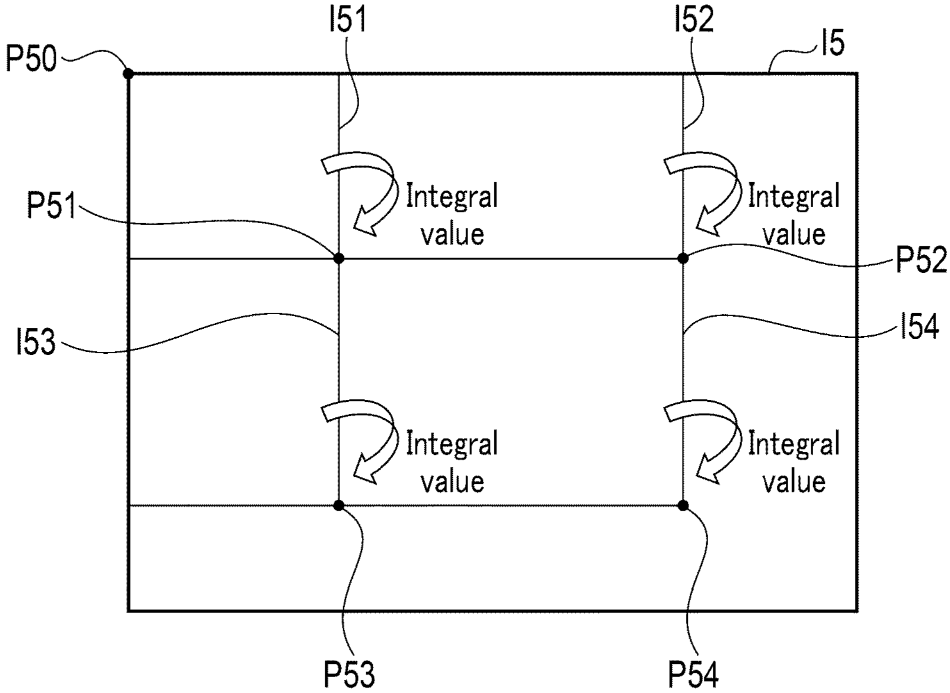
I51
I52
I5
P50
Integral value
Integral value
P51
P52
I53
I54
Integral value
Integral value
P53
P54

FIG. 4

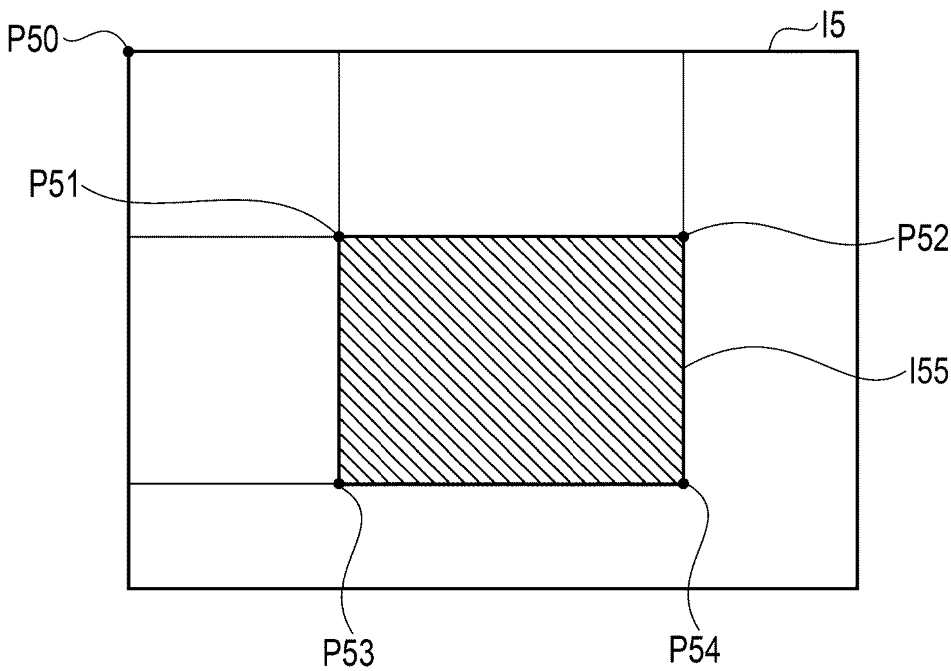
P50
I5
P51
P52
I55
P53
P54

FIG. 5

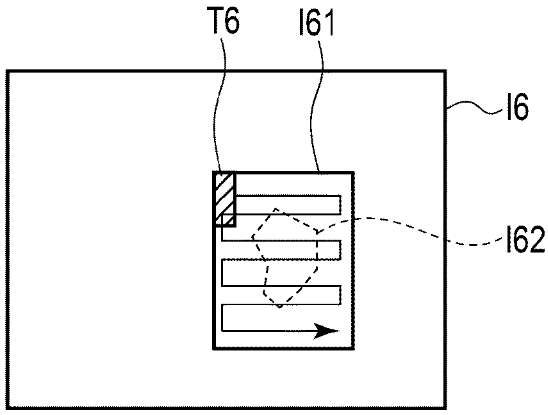


F I G. 6

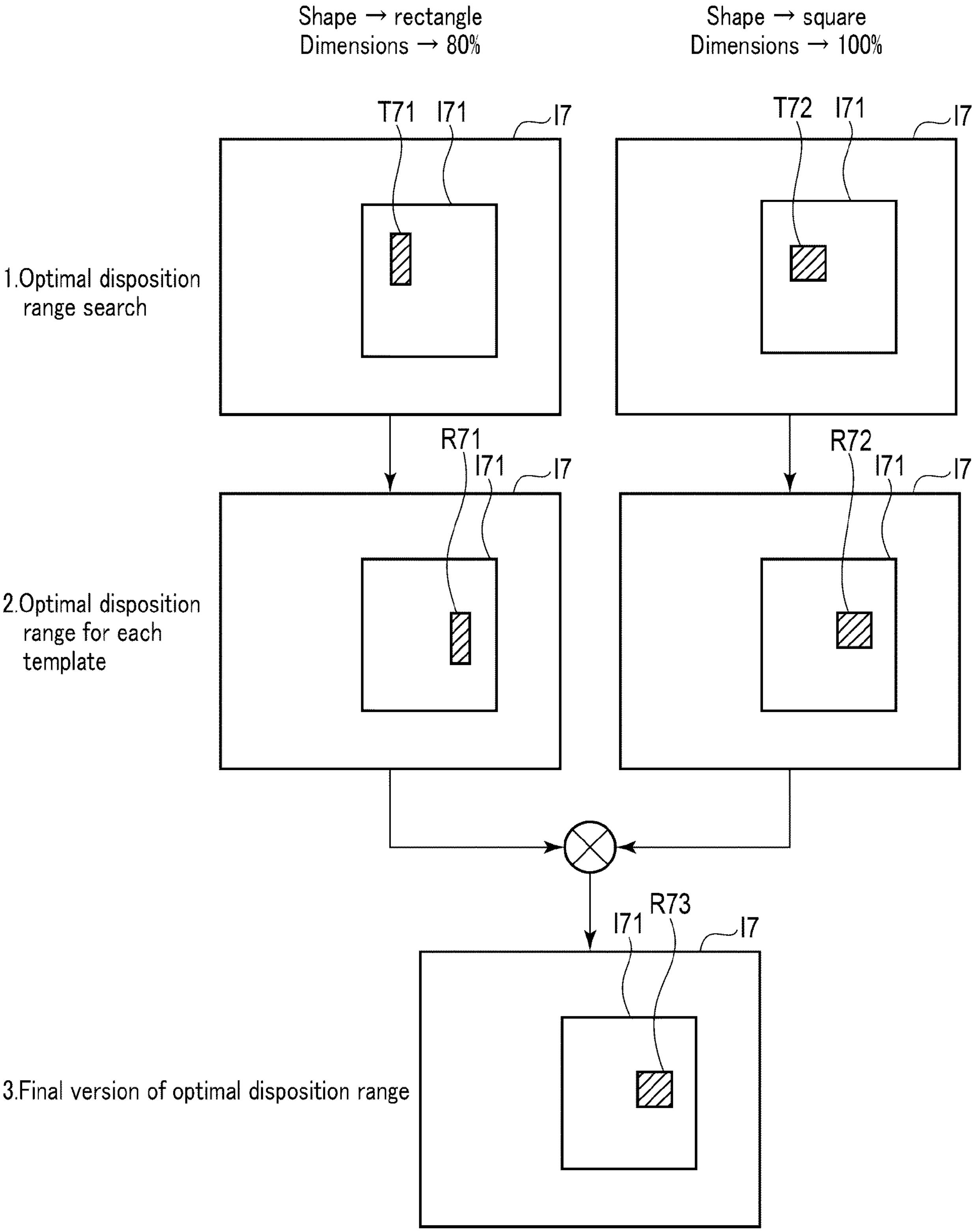
Shape → rectangle
Dimensions → 80%
Shape → square
Dimensions → 100%
T71
I71
I7
T72
I71
I7
1.Optimal disposition range search
R71
I71
I7
R72
I71
I7
2.Optimal disposition range for each template
I71
R73
I7
3.Final version of optimal disposition range

F I G. 7

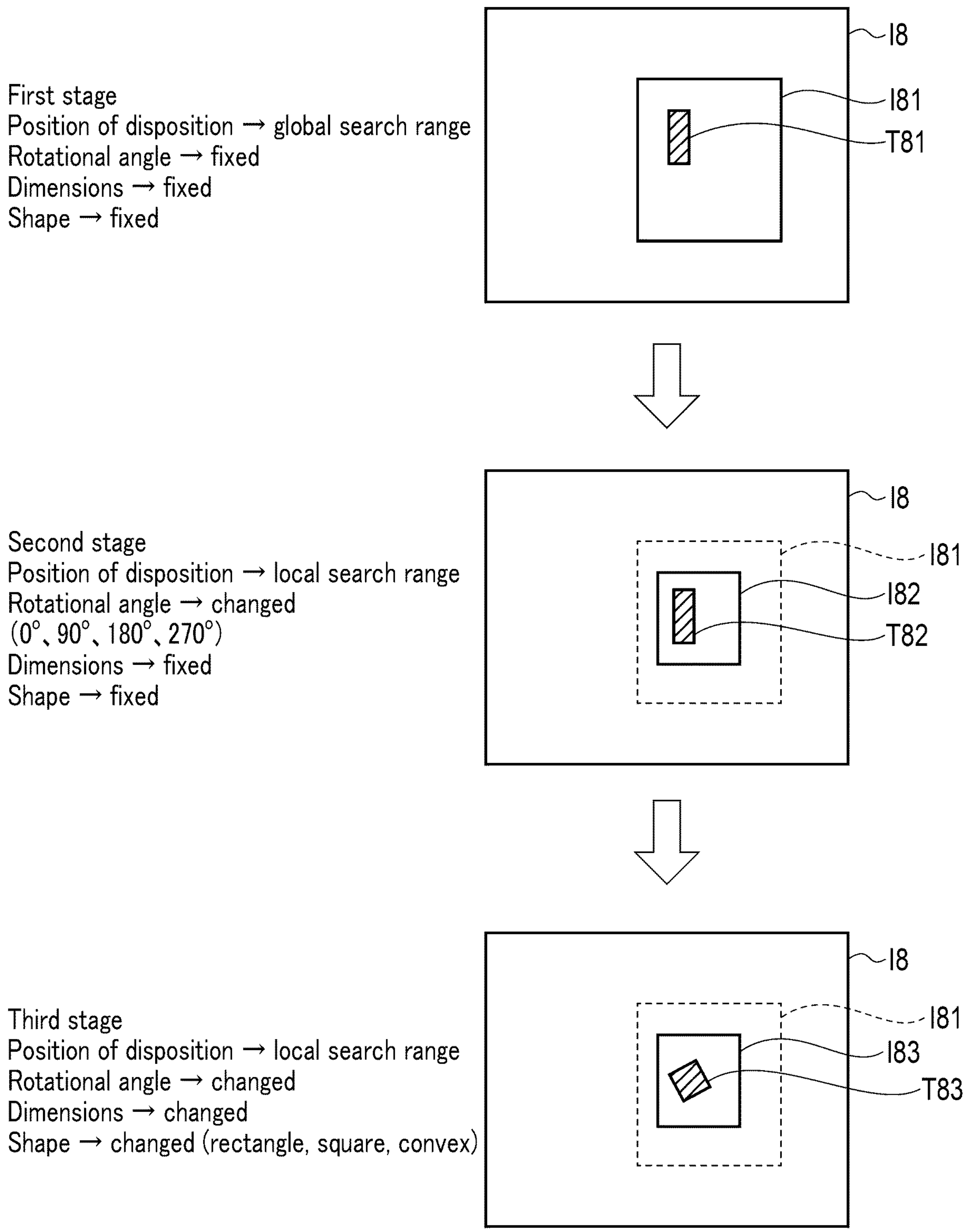
First stage
Position of disposition → global search range
Rotational angle → fixed
Dimensions → fixed
Shape → fixed
I8
I81
T81
Second stage
Position of disposition → local search range
Rotational angle → changed
(0°、90°、180°、270°)
Dimensions → fixed
Shape → fixed
I8
I81
I82
T82
Third stage
Position of disposition → local search range
Rotational angle → changed
Dimensions → changed
Shape → changed (rectangle, square, convex)
I8
I81
I83
T83

FIG. 8

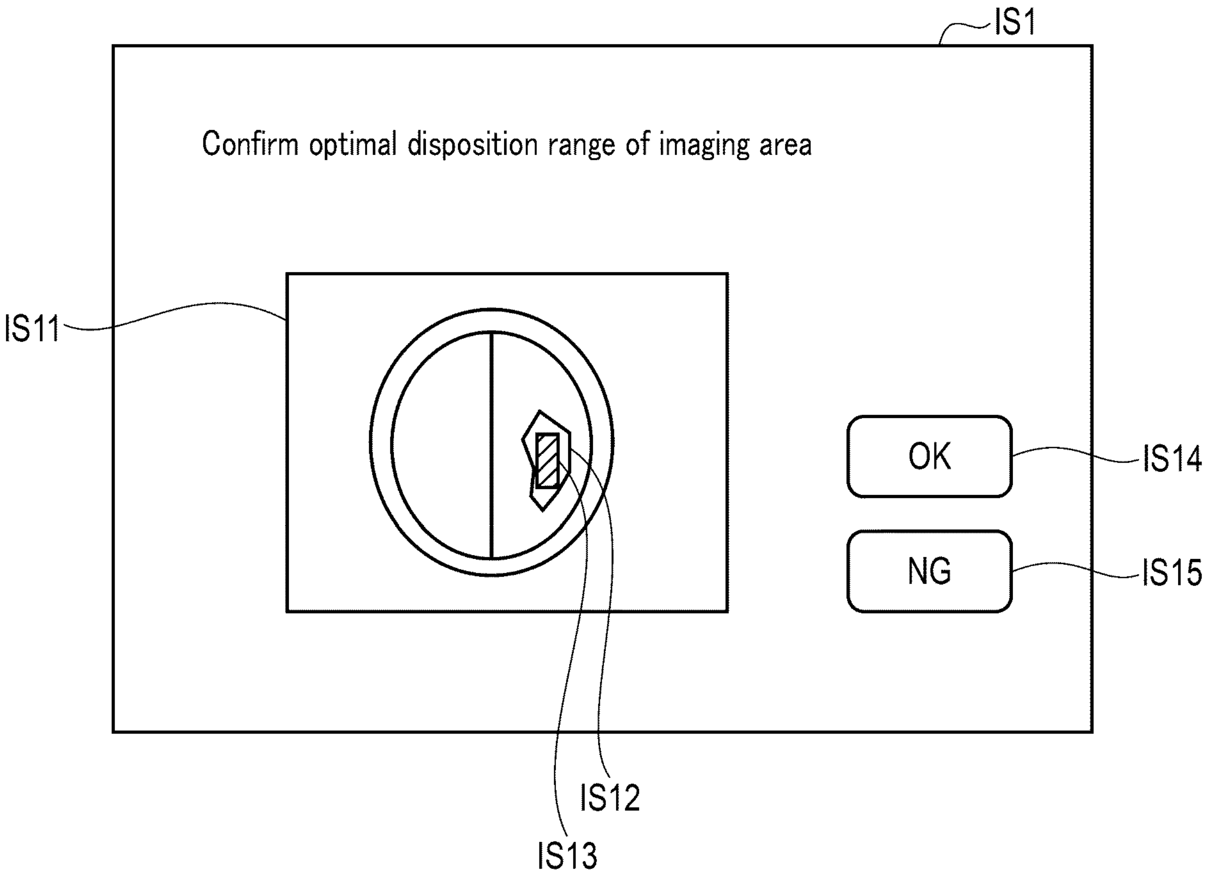
IS1
Confirm optimal disposition range of imaging area
IS11
OK
IS14
NG
IS15
IS12
IS13

F I G. 9

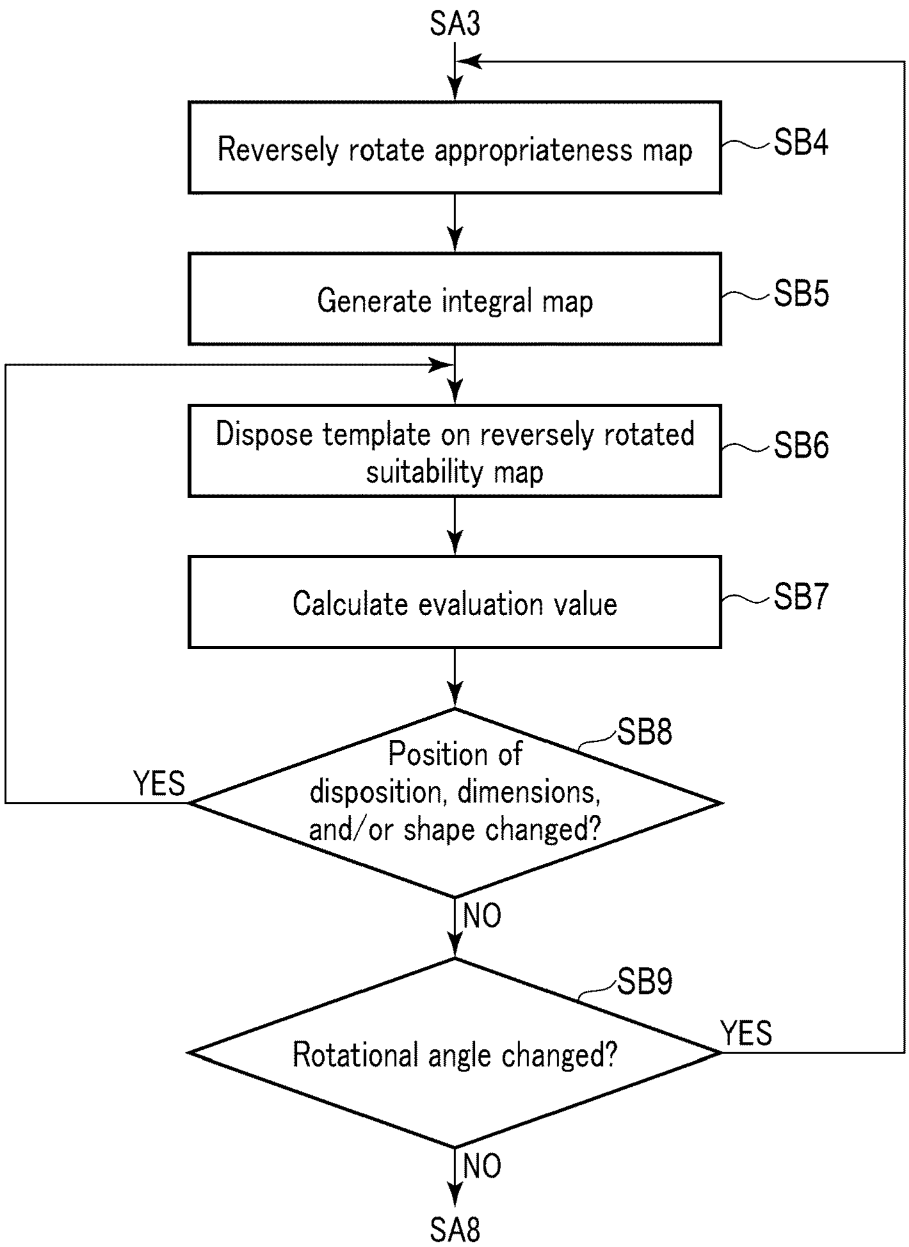
SA3
Reversely rotate appropriateness map
SB4
Generate integral map
SB5
Dispose template on reversely rotated suitability map
SB6
Calculate evaluation value
SB7
Position of disposition, dimensions, and/or shape changed?
SB8
YES
NO
Rotational angle changed?
SB9
YES
NO
SA8

F I G. 10

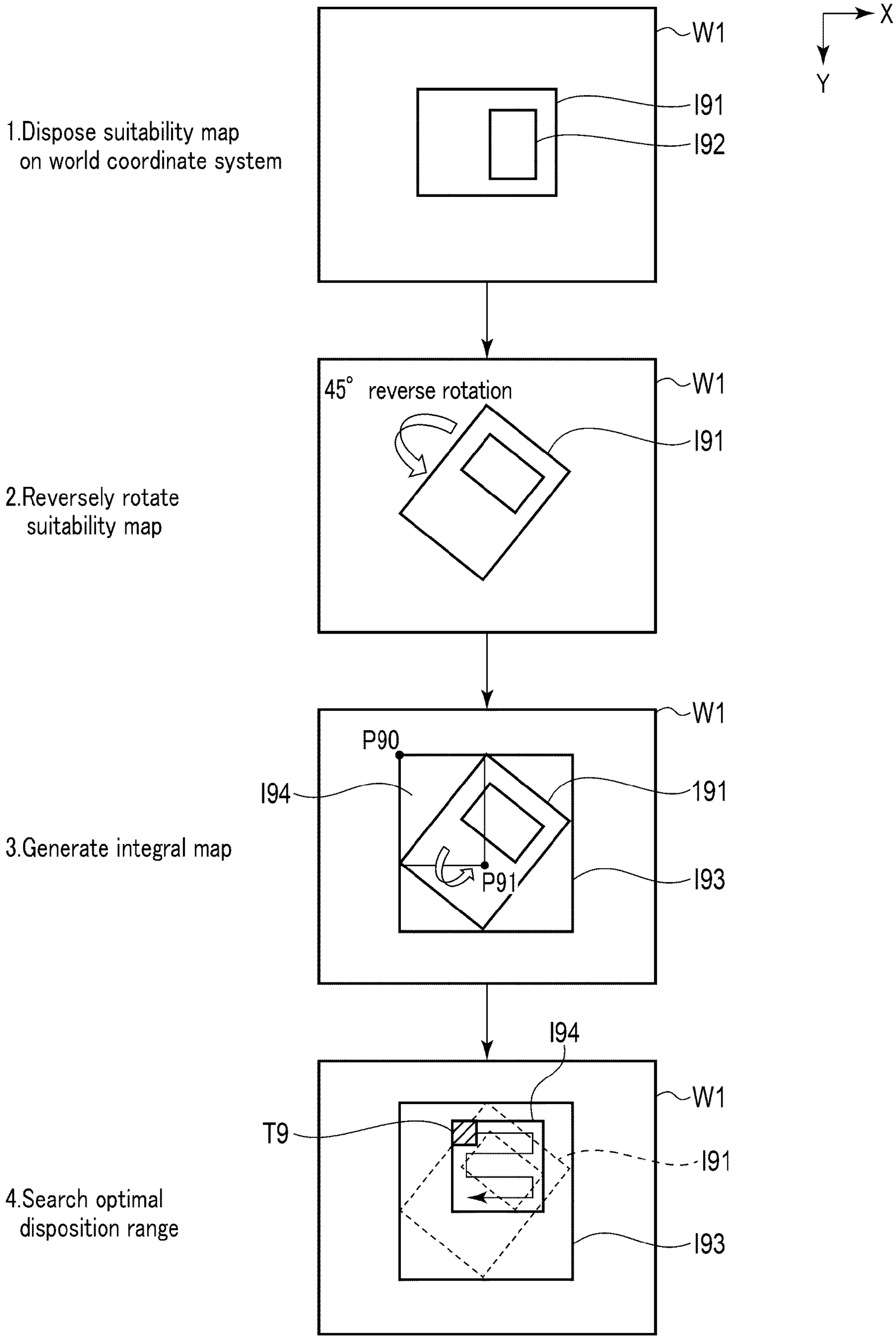
X
Y
W1
I91
I92
1.Dispose suitability map on world coordinate system
45° reverse rotation
W1
I91
2.Reversely rotate suitability map
W1
P90
I94
191
3.Generate integral map
P91
I93
I94
W1
T9
I91
4.Search optimal disposition range
I93

F I G. 11

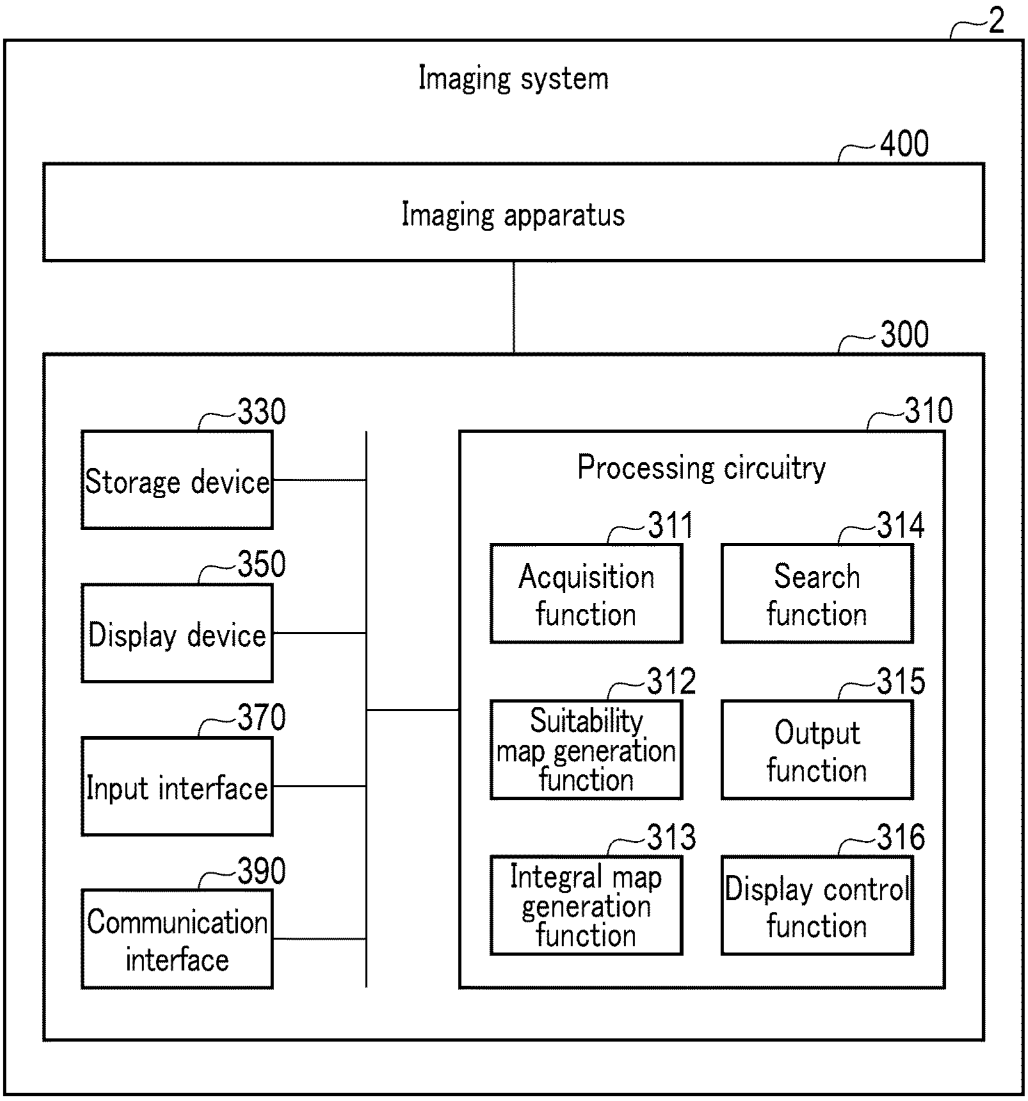
2
Imaging system
400
Imaging apparatus
300
330
Storage device
350
Display device
370
Input interface
390
Communication interface
310
Processing circuitry
311
Acquisition function
314
Search function
312
Suitability map generation function
315
Output function
313
Integral map generation function
316
Display control function

F I G. 12

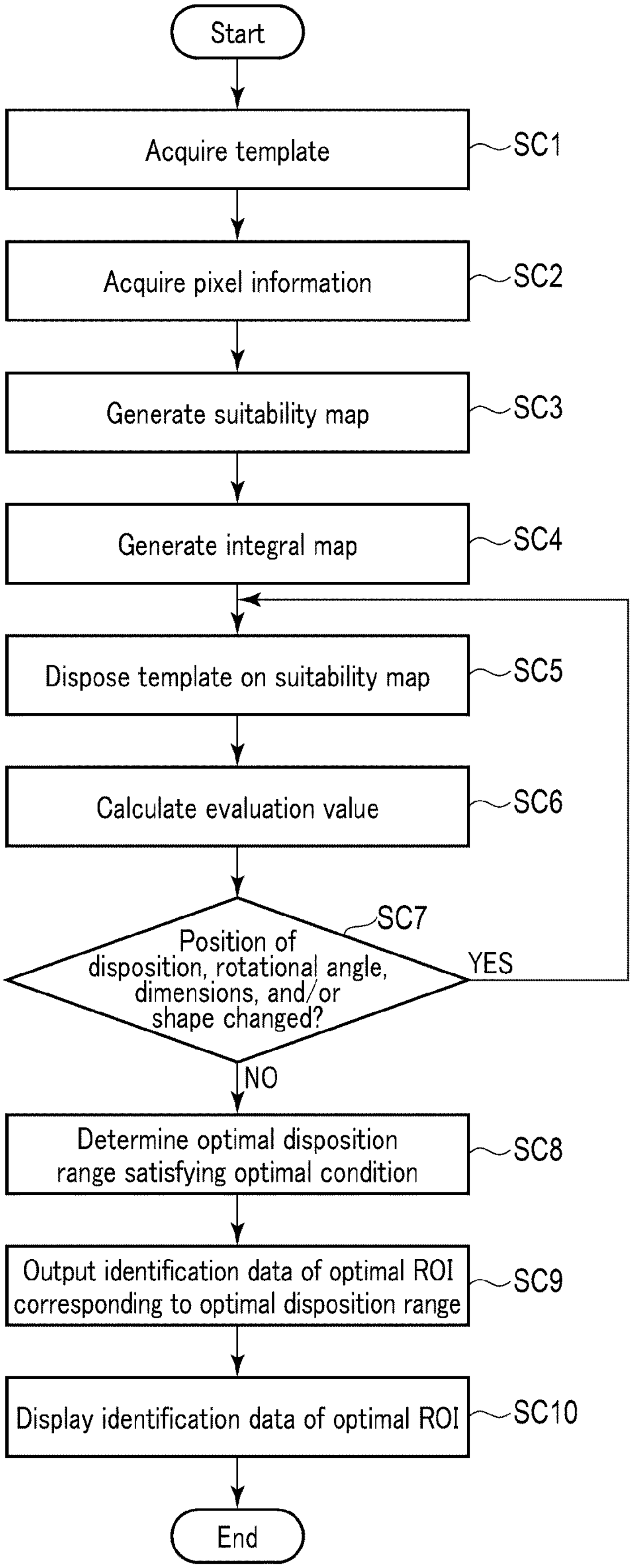
Start
Acquire template
SC1
Acquire pixel information
SC2
Generate suitability map
SC3
Generate integral map
SC4
Dispose template on suitability map
SC5
Calculate evaluation value
SC6
SC7
Position of disposition, rotational angle, dimensions, and/or shape changed?
YES
NO
Determine optimal disposition range satisfying optimal condition
SC8
Output identification data of optimal ROI corresponding to optimal disposition range
SC9
Display identification data of optimal ROI
SC10
End

F I G. 13

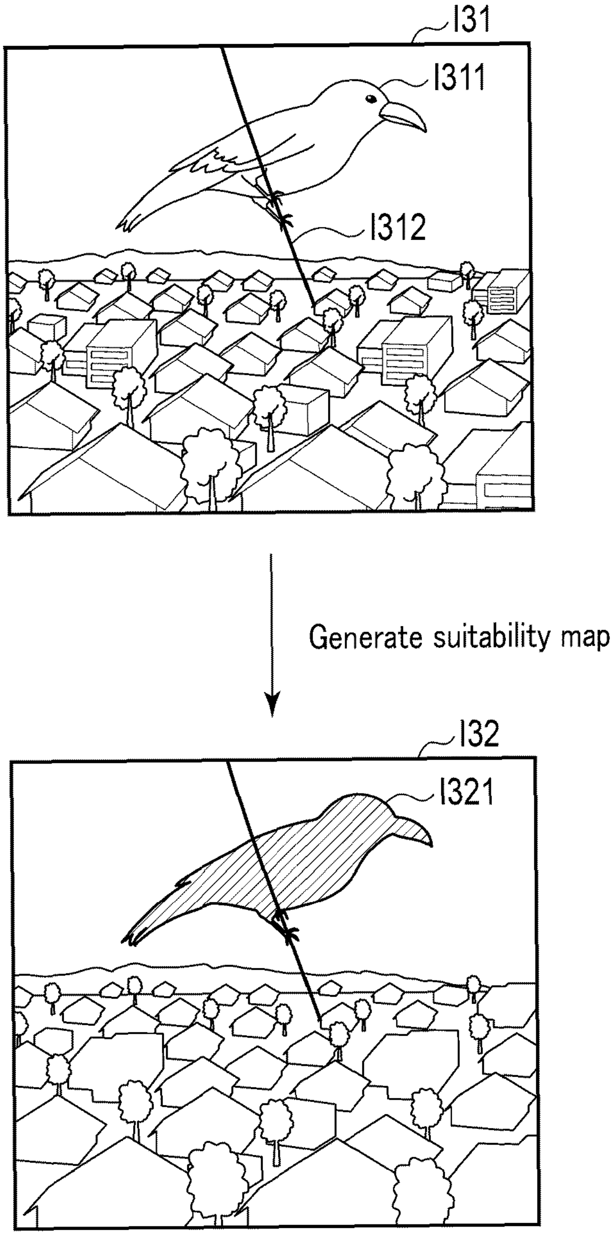


F I G. 14

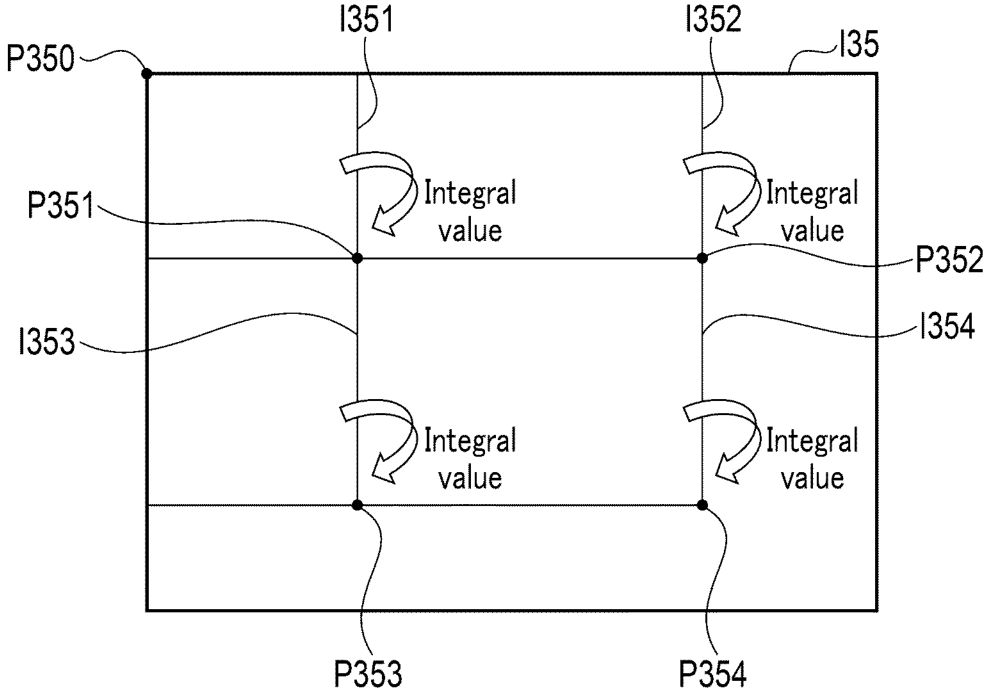
I351
I352
P350
I35
P351
Integral value
Integral value
P352
I353
I354
Integral value
Integral value
P353
P354

F I G. 15

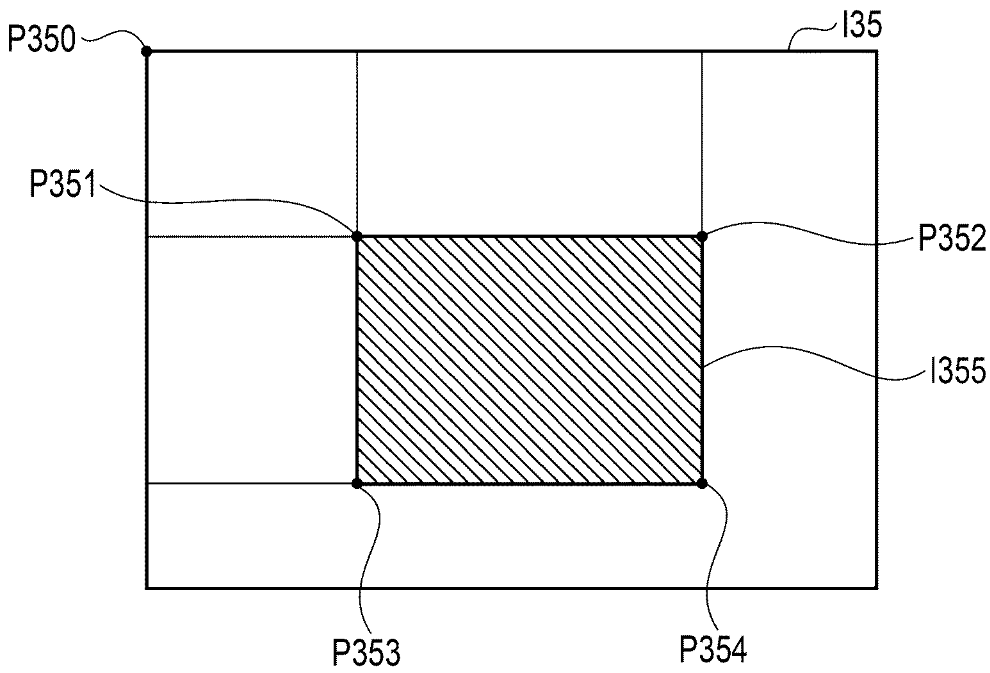
P350
I35
P351
P352
I355
P353
P354

F I G. 16

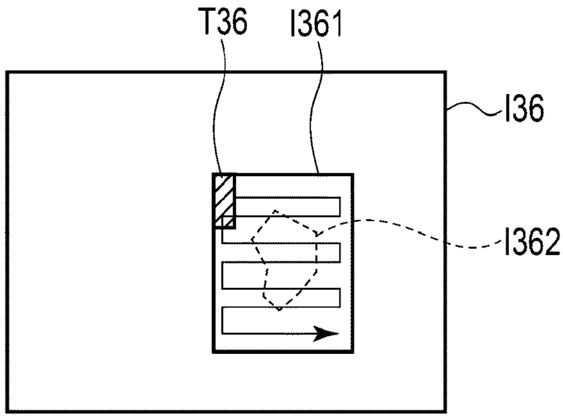


F I G. 17

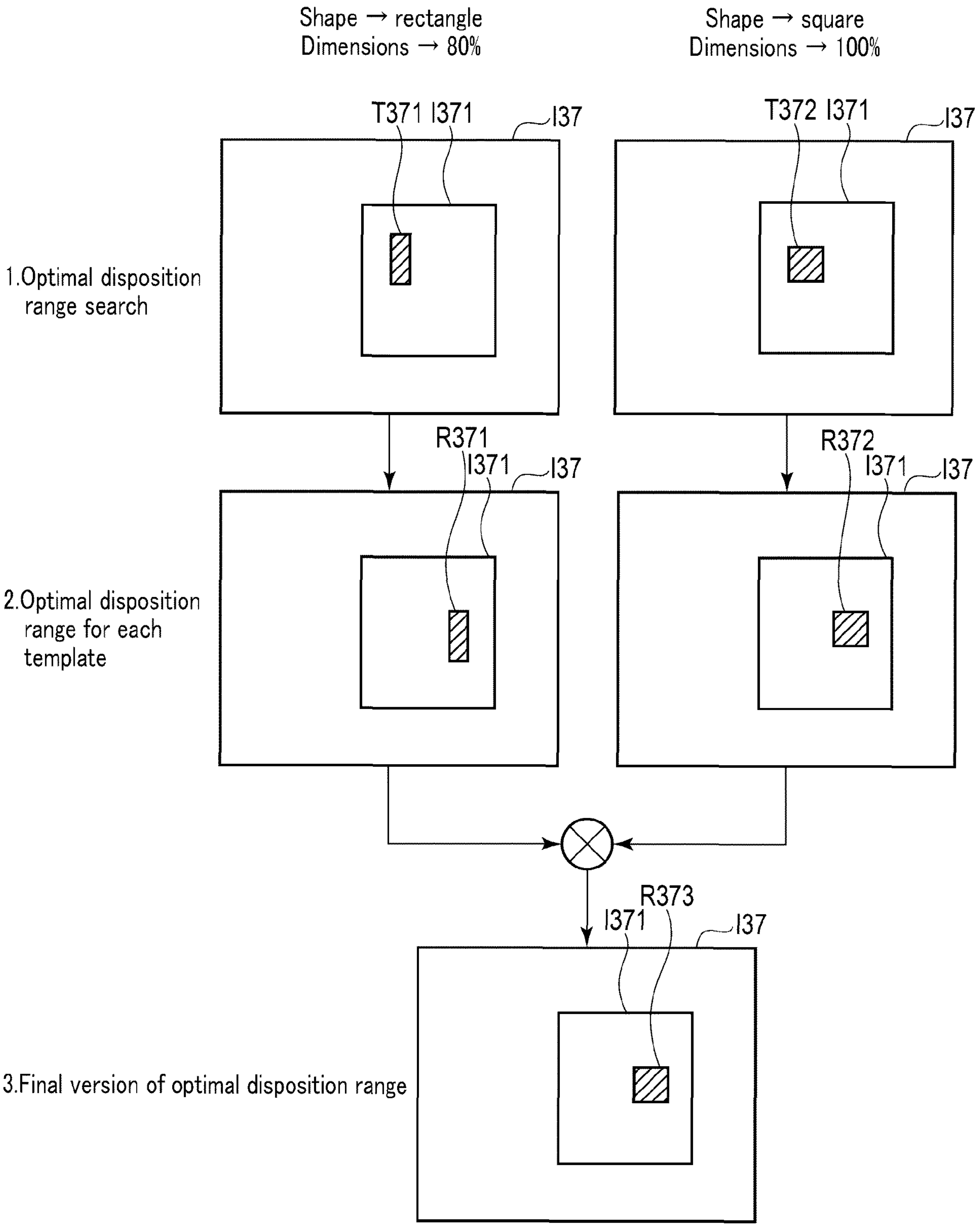
Shape → rectangle
Dimensions → 80%
Shape → square
Dimensions → 100%
T371 I371
I37
T372 I371
I37
1.Optimal disposition range search
R371
I371
I37
R372
I371
I37
2.Optimal disposition range for each template
R373
I371
I37
3.Final version of optimal disposition range

F I G. 18

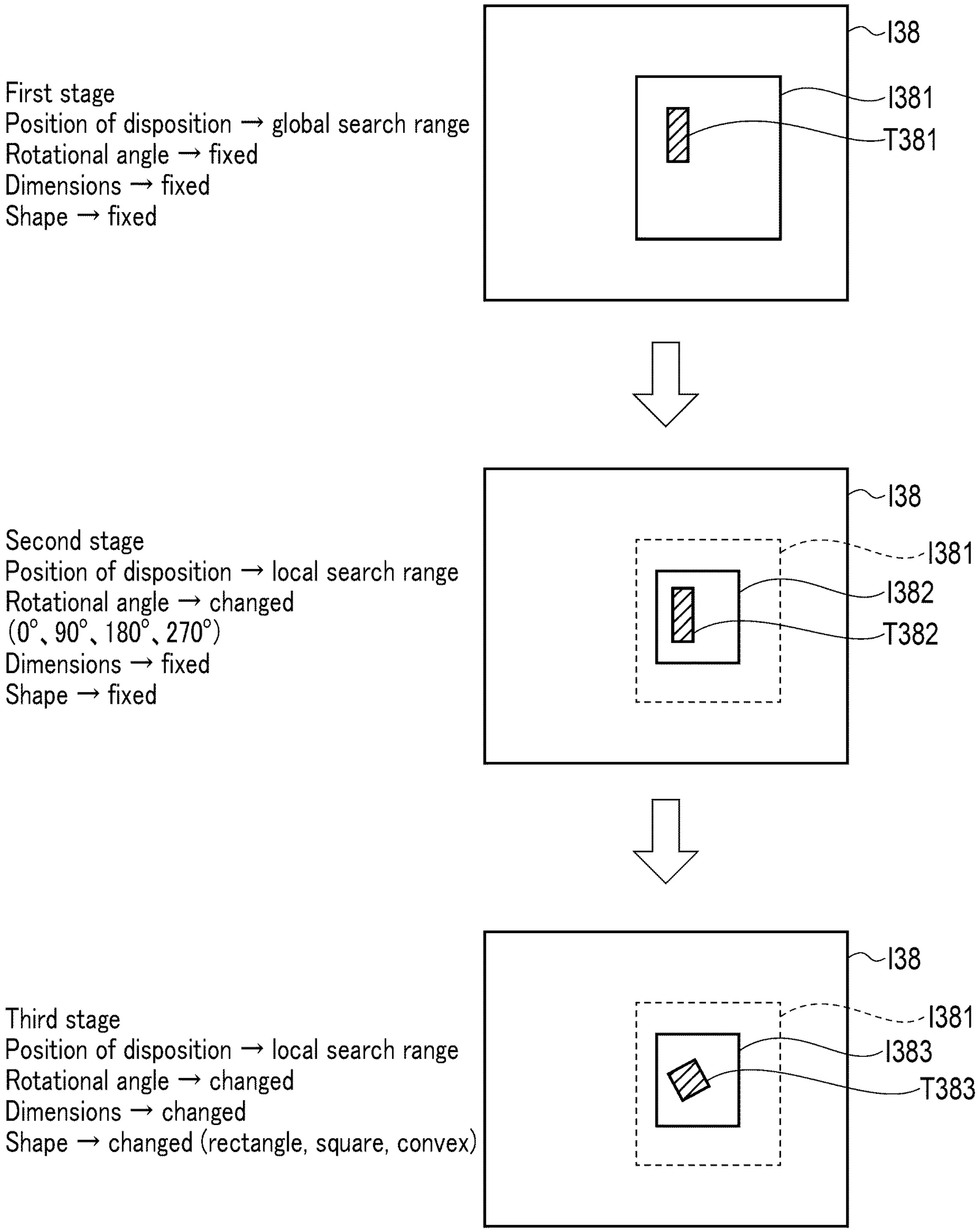
I38
I381
T381
First stage
Position of disposition → global search range
Rotational angle → fixed
Dimensions → fixed
Shape → fixed
I38
I381
I382
T382
Second stage
Position of disposition → local search range
Rotational angle → changed
(0°、90°、180°、270°)
Dimensions → fixed
Shape → fixed
I38
I381
I383
T383
Third stage
Position of disposition → local search range
Rotational angle → changed
Dimensions → changed
Shape → changed (rectangle, square, convex)

F I G. 19

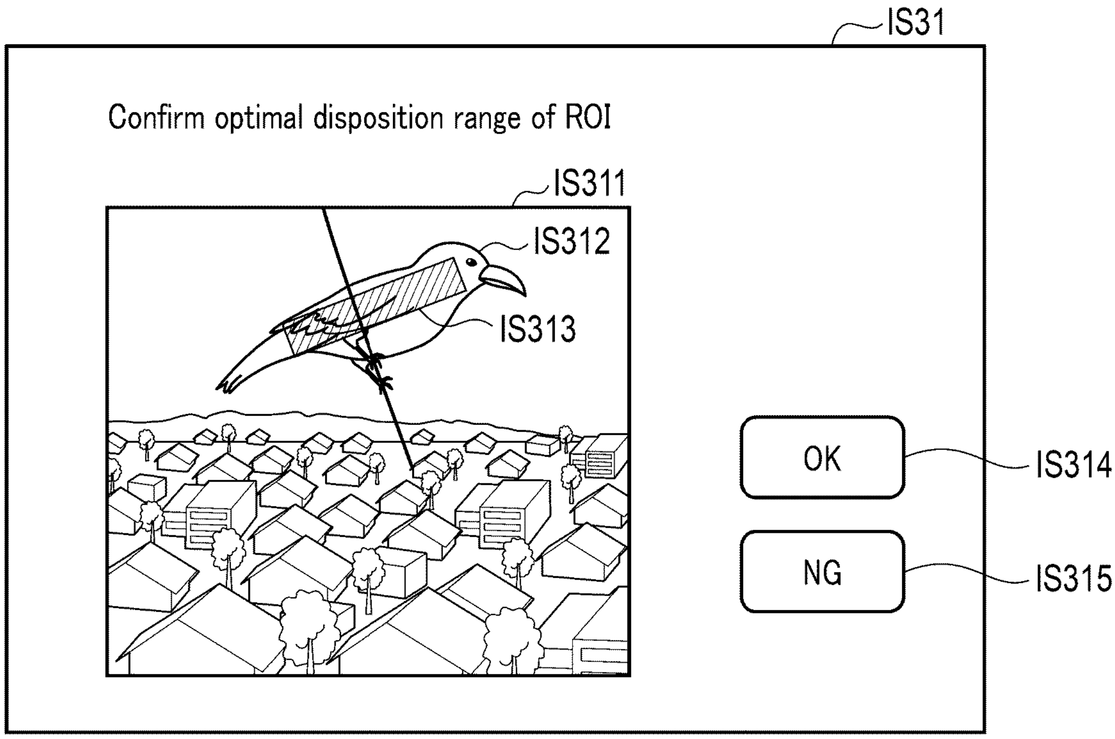
IS31
Confirm optimal disposition range of ROI
IS311
IS312
IS313
OK
NG
IS314
IS315

F I G. 20

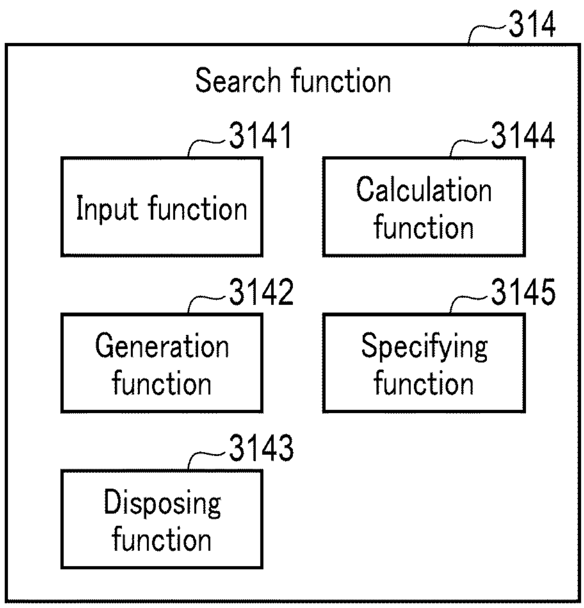
314
Search function
3141
Input function
3144
Calculation function
3142
Generation function
3145
Specifying function
3143
Disposing function

F I G. 21

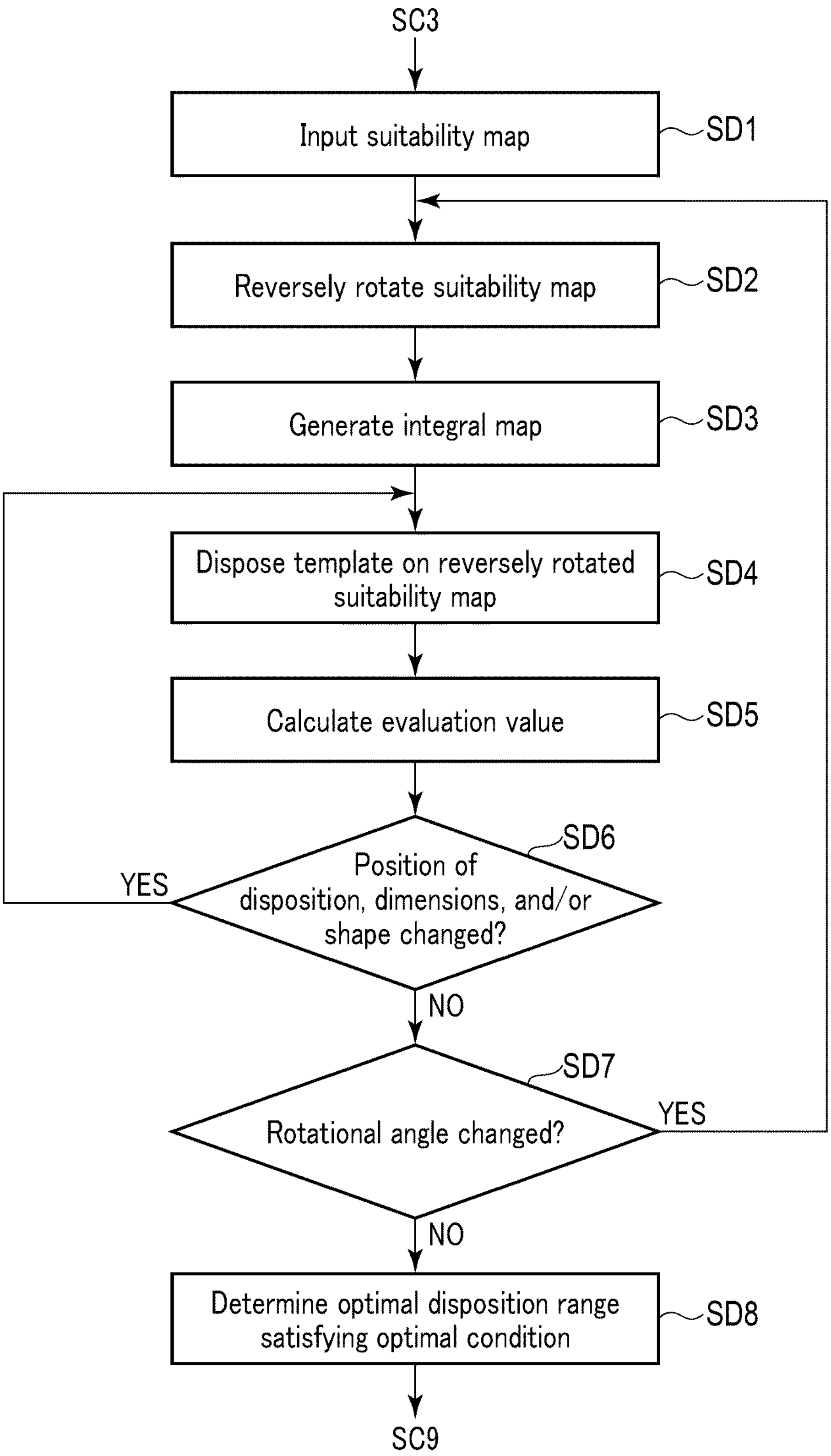
SC3
Input suitability map
SD1
Reversely rotate suitability map
SD2
Generate integral map
SD3
Dispose template on reversely rotated suitability map
SD4
Calculate evaluation value
SD5
Position of disposition, dimensions, and/or shape changed?
SD6
YES
NO
Rotational angle changed?
SD7
YES
NO
Determine optimal disposition range satisfying optimal condition
SD8
SC9

F I G. 22

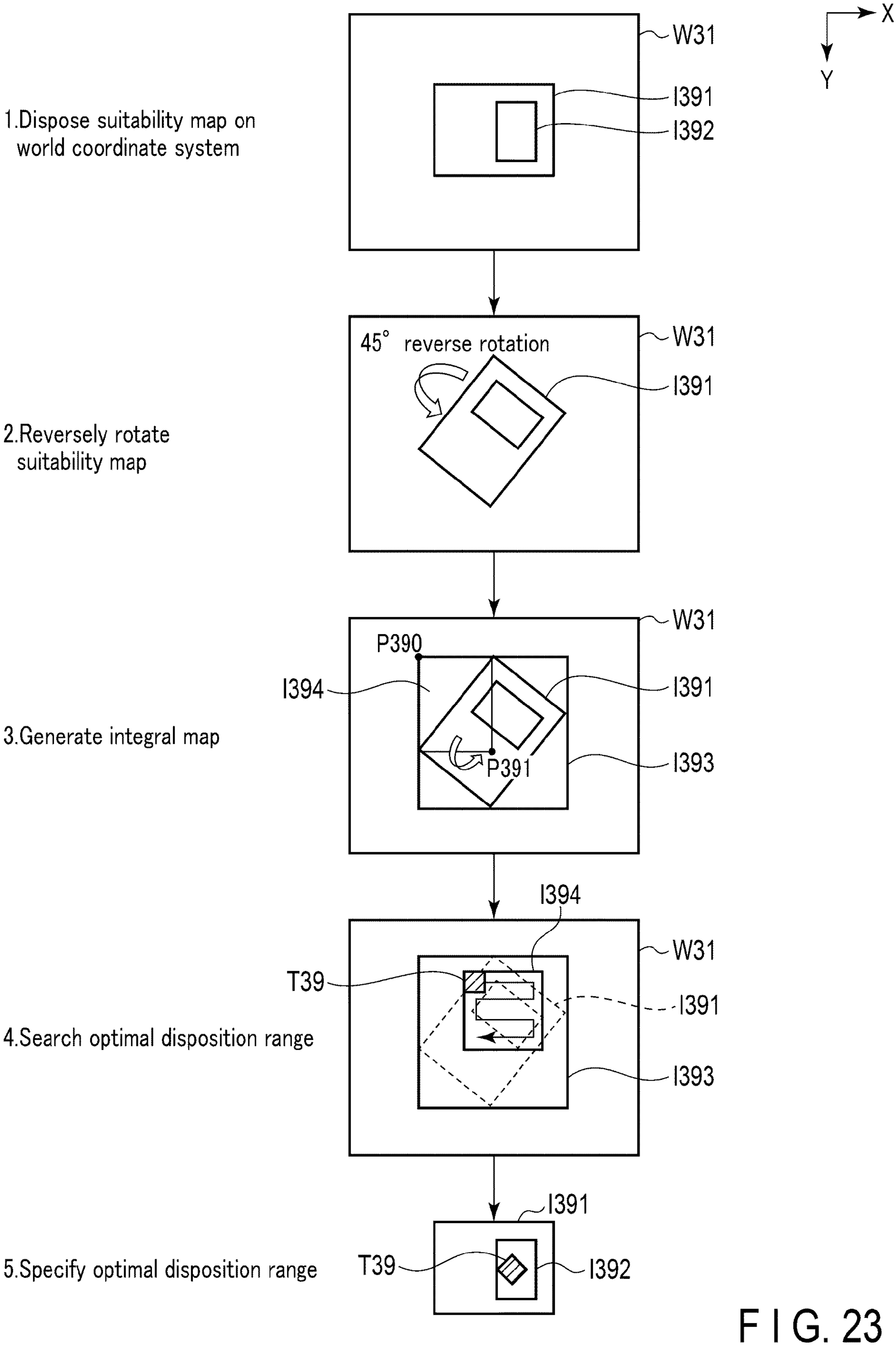
X
Y
1.Dispose suitability map on world coordinate system
W31
I391
I392
2.Reversely rotate suitability map
45° reverse rotation
W31
I391
3.Generate integral map
P390
I394
W31
I391
P391
I393
4.Search optimal disposition range
I394
T39
W31
I391
I393
5.Specify optimal disposition range
I391
T39
I392

F I G. 23

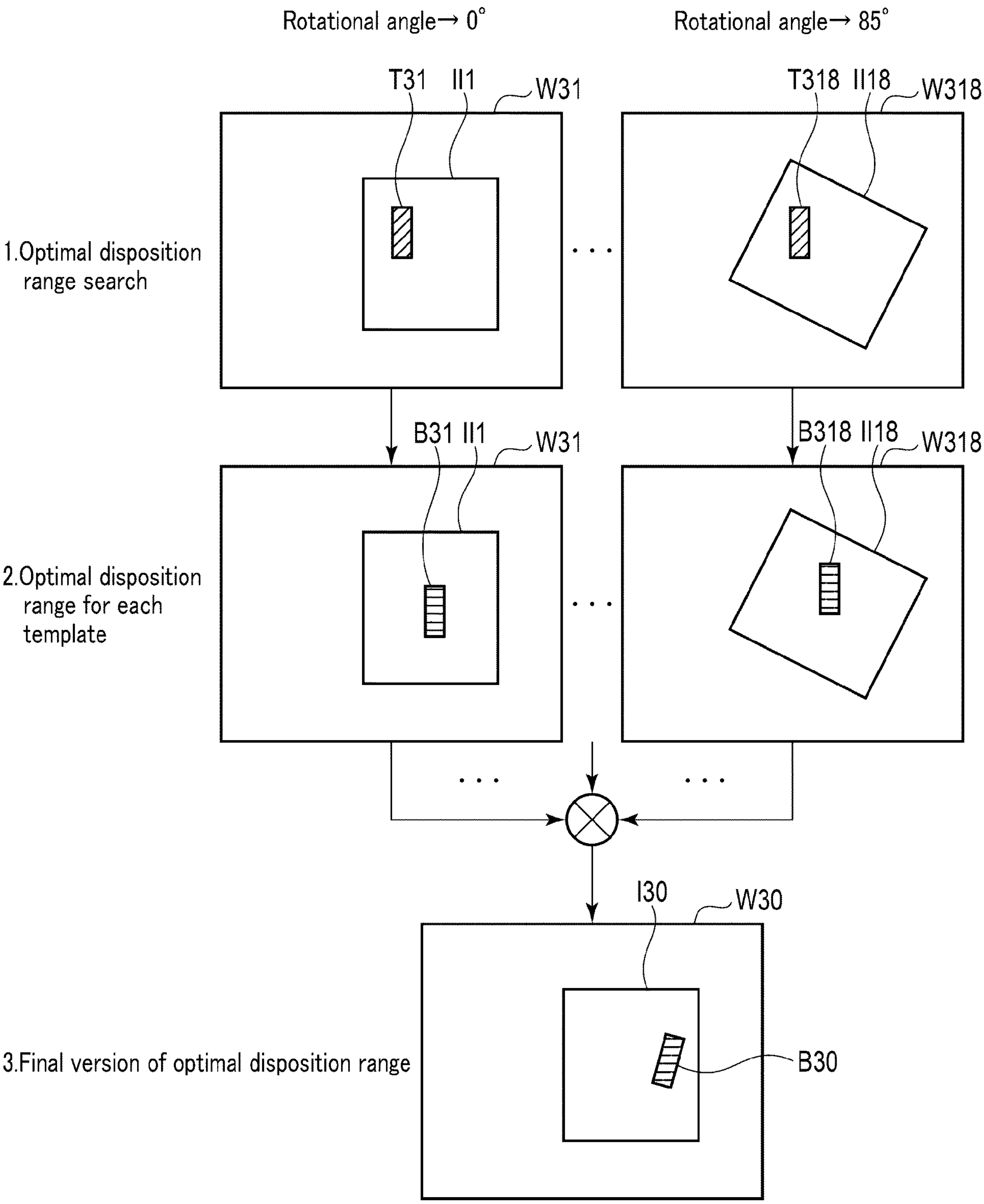
Rotational angle→ 0°
Rotational angle→ 85°
T31
II1
W31
T318
II18
W318
1.Optimal disposition range search
B31
II1
W31
B318
II18
W318
2.Optimal disposition range for each template
I30
W30
3.Final version of optimal disposition range
B30

F I G. 24

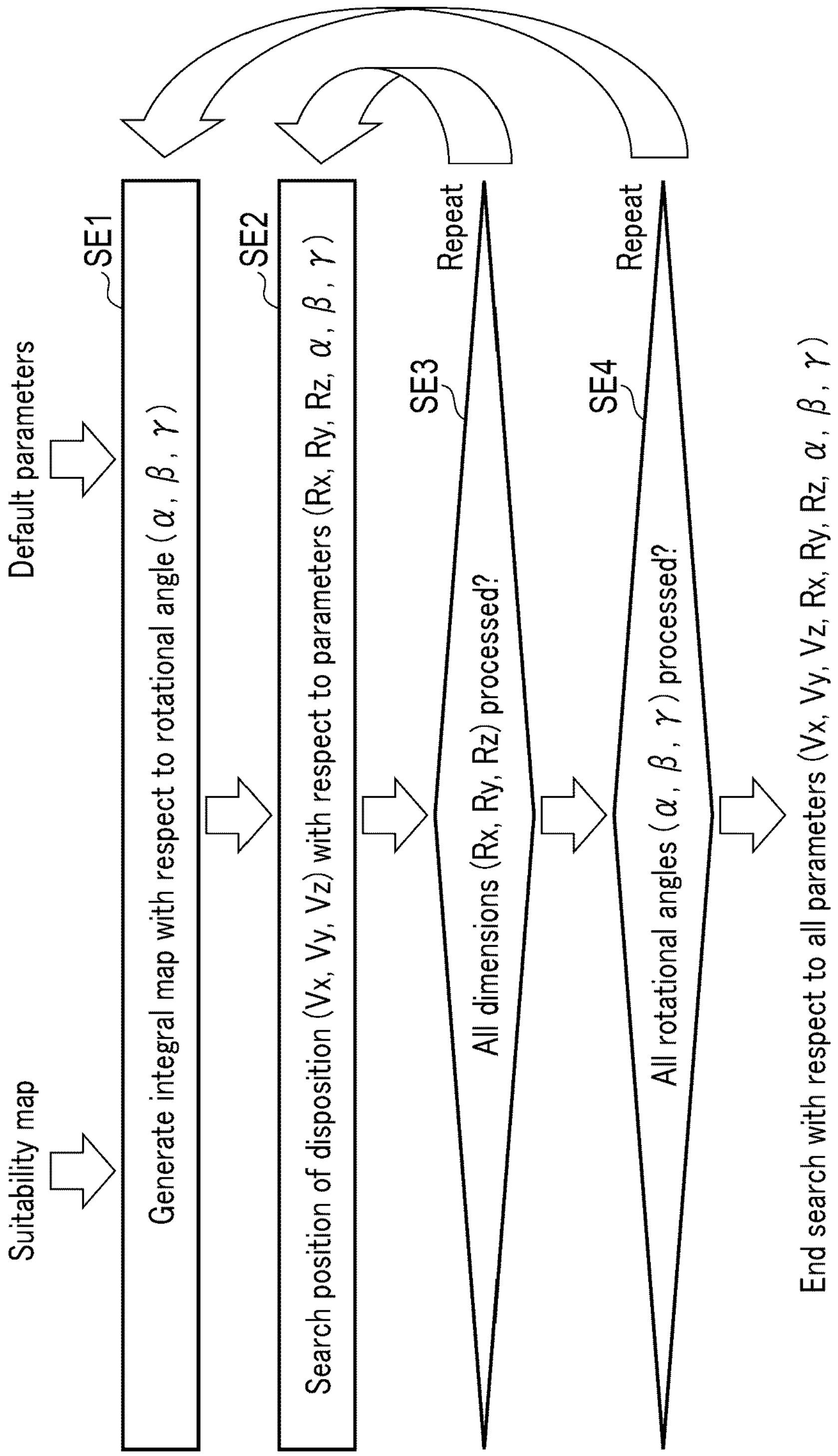

Suitability map
Default parameters
SE1
Generate integral map with respect to rotational angle (α, β, γ)
SE2
Search position of disposition (Vx, Vy, Vz) with respect to parameters (Rx, Ry, Rz, α, β, γ)
SE3
All dimensions (Rx, Ry, Rz) processed?
Repeat
SE4
All rotational angles (α, β, γ) processed?
Repeat
End search with respect to all parameters (Vx, Vy, Vz, Rx, Ry, Rz, α, β, γ)


FIG. 25

Europäisches Patentamt
European Patent Office
Office européen des brevets

# EUROPEAN SEARCH REPORT

Application Number
EP 25 21 2652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 107 689 057 A (INST HIGH ENERGY PHYSICS CAS) 13 February 2018 (2018-02-13)<br>* the whole document *<br>----- | 1-20 | INV.<br>G06V10/22<br>G06T3/00<br>G06V20/64 |
| A | US 2012/197104 A1 (POSSE STEFAN [US] ET AL) 2 August 2012 (2012-08-02)<br>* the whole document *<br>----- | 1-20 | |
| A | US 10 641 854 B2 (UNIV MINNESOTA [US]) 5 May 2020 (2020-05-05)<br>* the whole document *<br>----- | 1-20 | |

TECHNICAL FIELDS SEARCHED (IPC)

G06V
G06T

The present search report has been drawn up for all claims

3

| Place of search | Date of completion of the search | Examiner |
|---|---|---|
| The Hague | 18 February 2026 | de Bont, Emma |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 21 2652

This annex lists the patent family members relating to the patent documents cited in the above-mentioned European search report. The members are as contained in the European Patent Office EDP file on
The European Patent Office is in no way liable for these particulars which are merely given for the purpose of information.

18-02-2026

| Patent document cited in search report | Publication date | Patent family member(s) | Publication date |
|---|---|---|---|
| CN 107689057 A | 13-02-2018 | NONE | |
| US 2012197104 A1 | 02-08-2012 | US 2012197104 A1 | 02-08-2012 |
| | | WO 2011050348 A2 | 28-04-2011 |
| US 10641854 B2 | 05-05-2020 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2024193101 A
- JP 2024193107 A
- JP 2025074423 A

### Non-patent literature cited in the description


- **VIOLA, P.** ; **JONES, M.** Rapid object detection using a boosted cascade of simple features. *Proceedings of the 2001 IEEE Computer Society Conference on Computer Vision and Pattern Recognition. CVPR 2001*
- **VIOLA, P.** ; **JONES, M.** Rapid object detection using a boosted cascade of simple features. *Proceedings of the 2001 IEEE Computer Society Conference on Computer Vision and Pattern Recognition. CVPR 2001*, 2001
- **REOXIANG LI** ; **BING ZENG** ; **M. L. LIOU**. A new three-step search algorithm for block motion estimation. *IEEE Transactions on Circuits and Systems for Video Technology*, August 1994, vol. 4 (4), 438-442
- **SHAN ZHU** ; **KAI-KUANG MA**. A new diamond search algorithm for fast block-matching motion estimation. *IEEE Transactions on Image Processing*, February 2000, vol. 9 (2), 287-290